# EUROPÄISCHE PATENTSCHRIFT

(11) **EP 4 103 351 B1**
(45) Veröffentlichungstag und Bekanntmachung des Hinweises auf die Patenterteilung: **03.04.2024**
(21) Anmeldenummer: 21709881.3
(22) Anmeldetag: 08.02.2021
(51) Int. Cl.: B23K 35/02, B23K 35/26, C22C 13/00, H01L 23/373

(54) **BLEIFREIE LÖTFOLIE**
LEAD-FREE SOLDER FOIL
FEUILLE DE SOUDURE SANS PLOMB

(30) Priorität: 12.02.2020 DE 102020000913
(43) Veröffentlichungstag der Anmeldung: 21.12.2022
(73) Patentinhaber: Pfarr Stanztechnik Gmbh, 36419 Buttlar / Thüringen (DE)
(72) Erfinder: MÄDLER, Ralph, 36037 Fulda (DE); REICHELT, Stephan, 36404 Unterbreizbach (DE)
(86) Internationale Anmeldenummer: PCT/DE2021/000021
(87) Internationale Veröffentlichungsnummer: WO 2021/160196

(56) Entgegenhaltungen:
- CN-A- 106 475 702
- DE-A1-102017 208 676
- JP-A- 2004 174 522
- JP-A- 2009 106 993
- US-A1- 2011 221 076

## Beschreibung

Die Erfindung betrifft eine bleifreie Lötfolie, mit welcher metallische Bauteile und/oder metallisierte/metallbeschichtete Bauteile, d.h. metallische Oberflächenschichten benachbarter Bauteile, miteinander verbunden werden können.

Zum Verbinden von Bauteilen in der Elektronikindustrie werden im Stand der Technik Lotwerkstoffe, zumeist sogenannte Weichlote sowohl in Form von Lotpaste aber auch als vorportionierte, rein metallische Lotformteile eingesetzt. Die Zuverlässigkeit von Lötstellen in der Elektronik und dabei insbesondere in der Leistungselektronik erfordert heute sehr gute mechanische, elektrische und thermische Eigenschaften der Lotmaterialien wie auch der mit Ihnen erzeugten Verbindungszonen, wobei deren Beständigkeit gegenwärtig auf immer höhere Temperaturbereiche ausgedehnt werden soll.

Der internationale Trend geht dabei aus Gründen des Umweltschutzes und der Gesundheitsunbedenklichkeit hin zum Einsatz von umweltfreundlichen und gesundheitsunbedenklichen bleifreien Lotmaterialien.

Im Zuge der Umstellung auf bleifreie Lote wurden zahlreiche Lotvariationen, größtenteils basierend auf Zinn, entwickelt, die im Vergleich zu den bleihaltigen Legierungen zwar auch gute mechanische, elektrische und thermische Eigenschaften aufweisen, jedoch im Bereich von ca. 214°C bis ca. 250°C aufschmelzen.

Für höhere Arbeits-/Einsatztemperaturen gibt es derzeitig keine bleifreien Weichlote, die die in der Leistungselektronik geforderte Temperaturbeständigkeit der Eigenschaften mit der notwendigen Zuverlässigkeit und Wirtschaftlichkeit vereinen.

Daher besteht beispielsweise bei Hochtemperaturanwendungen, d.h. insbesondere bei Arbeitstemperaturen über 250°C, die Notwendigkeit, neue kostengünstig zu verwendende (möglichst auch bleifreie) Weichlotfolien zu entwickeln, die den in der Leistungselektronik benötigten Anforderungen an die Temperaturführung gerecht werden, um einerseits während des Lötprozesses die zu verbindenden Baugruppen nicht zu beschädigen und andererseits, auch unter dem Gesichtspunkt der Wirtschaftlichkeit, insbesondere mit den für Weichloten typischen Lötprofilen, in einem für das bleifreie Weichlöten typischen Prozesstemperaturgebiet, d.h. bei vorzugsweise von 250 bis 300°C, aber mindestens 20-30 K über den Liquidustemperaturen der verwendeten Weichlote und mit dem im Stand der Technik üblichen Lötzeiten unter 5 min und auch ohne eine anschließende Wärmebehandlung und selbst ohne die zusätzliche Ausübung eines Anpressdruckes auf die Fügepartner während des Lötens, und unabhängig von den beim Löten einzustellenden Atmosphären im Lötofen bei minimalster Ausbildung von Poren und/oder Lunkern in der Verbindungszone eine hochtemperaturbeständige Lotverbindung zu erzielen, die eine hohe thermische Zuverlässigkeit der Verbindungszonen zwischen den benachbarten Bauteilen auch in Stufenlötprozessen gewährleistet.

Um eine derartige Verbindung zwischen den Bauteilen herstellen zu können, müssen die Lote stets in den schmelzflüssigen Zustand überführt werden. Nach dem Abkühlen und Erstarren des Lotes ist zwischen den Komponenten eine feste, stoffschlüssige Verbindung hergestellt. Es ist ein Nachteil der Lotfolien des Standes der Technik, dass das Lot, einmal in den schmelzflüssigen Zustand überführt, keinerlei nennenswerten inneren Widerstand (Oberflächenspannung des flüssigen Lotes) gegenüber Formänderung durch von außen einwirkende Kräfte besitzt.

Diese von außen einwirkenden Kräfte können dabei Gewichtskräfte, welche aus dem Gewicht der zu verbindenden Bauteile resultieren, aber auch aus der Verbindungstechnologie resultierende Schub- und Druckkräfte, wie auch Kapillaritätskräfte, oder durch den Einfluss von Oberflächenspannungen hervorgerufene Kräfte, wie auch durch die atomaren Wechselwirkungskräfte in Verbindung mit der Geometrie der Fügestelle/Verbindungszone beim Löten hervorgerufene Kräfte sein.

Diese Kräfte können beim Lötvorgang ein Verkippen der zu fügenden Bauteile zueinander zur Folge haben.

Dadurch ist nach dem Löten die Lotdicke, im Querschnitt betrachtet, an einer Kante des Aufbaus wesentlich dünner als an der gegenüberliegenden Kante. Diese unterschiedlichen Querschnittdicken des Lotmaterials über die zu lötenden Oberflächen haben einen negativen Einfluss auf die Lebensdauer der Lötstelle, gleichzeitig erhöht sich dadurch der Wärmewiderstand an/in den "dicken" Bereichen, wodurch unerwünschte sogenannte "Hotspots" ausgebildet werden.

In extremen Fällen kann es zum gänzlichen Verlust der Funktionalität von oberflächenmontierten (SMD-) Bauteilen kommen, wenn sich diese beim "Tombstone Effekt" in der flüssig gewordenen Lötstelle aufstellen.

Im Bereich der Aufbau- und Verbindungstechnik der Leistungselektronik weisen bleifrei gelötete Lötstellen im Vergleich zu ihren hoch-bleihaltigen Pendants zumeist eine deutlich verminderten Lebensdauer auf, die durch eine geringere Anzahl von Temperaturlastwechselzyklen bis zum Versagen der jeweils gelöteten Baugruppen gekennzeichnet ist.

Hochbleihaltige Lote werden daher auch heute noch in sensiblen Bereichen, wie der Luft- und Raumfahrt- oder der Militärtechnik eingesetzt, obwohl die Toxizität des Bleis für Mensch und Natur allgemein bekannt ist.

Andere Lösungen, wie das Sintern mit Kupfer- oder Silberpulvern in Pastenform oder die Verwendung von sehr spröden hochgoldhaltigen Weichloten, sind sehr kostenintensiv und kommen daher in diesen Bereichen als Alternative kaum in betracht.

Neben diesen thermo-mechanischen Vorteilen haben bleihaltige, insbesondere hochbleihaltige Lote den Vorteil, erst bei höheren Temperaturen schmelzflüssig zu werden als die übrigen, konventionellen, bleifreien Weichlote. Dadurch ist eine sichere Auslegung von sogenannten Stufenlötprozessen, bei denen die einzelnen Ebenen eines Moduls nacheinander durch Löten aufgebaut werden, mit hochbleihaltigen Loten möglich.

So kann beispielsweise die erste Lötstelle mit einem höherschmelzenden hochbleihaltigen Lot ausgeführt werden, eine Nachfolgelötstelle wird dann mit einem niedrigschmelzenderen Zinnbasislot ausgelegt.

Aufgrund einer Temperaturdifferenz in den Schmelzbereichen von 80 K (Kelvin) und mehr, besteht bei derartigen Auslegungen im Prinzip keine Gefahr, dass sich eine bereits aufgelötete Komponente bei einem Nachfolgelötschritt für die nächste Komponente lösen wird, da der Temperaturabstand zur Solidustemperatur des ersten Lotes groß genug und damit gut kontrollierbar ist. Ist man auf ein bleifreies Weichlot des allgemeinen Standes der Technik beschränkt, schwindet dieser Temperaturabstand zwischen der Wiederaufschmelztemperatur der bereits gelöteten Lötverbindung und der Schmelztemperatur der neu zu lötenden Lötstelle auf etwas mehr als 30 K für die unterschiedlichen bleifreien Zinnbasislote.

In der industriellen Praxis ist jedoch beim Löten in Vakuum-Reflowlötanlagen eine Überhitzung von ca. 20-30 K über die Liquidustemperatur der Lote allgemein üblich um qualitativ hochwertige Verbindungen zu erzeugen.

Daher existieren im Stand der Technik als niedrigschmelzendere Alternativen noch Indium- und Bismuthaltige Lote, welche für eine sichere bleifreie Auslegung von Stufenlötungen verwendet werden können.

Die sehr niedrigen Schmelztemperaturen der Indium- und Bismuthaltigen Lote wie auch daran gekoppelt, die schlechte Kriechbeständigkeit schränken jedoch deren Einsatz in der Leistungselektronik stark ein.

Zudem ist Indium ein sehr teures Metall, so dass dessen Einsatz als großflächiges, hochvoluminöses Systemlot vielfach unwirtschaftlich ist.

Auf Grund des baldigen Auslaufens der Ausnahmeregelungen für den weiteren Einsatz von bleihaltigen Loten in den konventionellen, nicht von Ausnahmeregelungen für Blei betroffenen Wirtschaftsbereichen, fehlen alternative Lotwerkstoffe die die Lücke, mit Bezug auf Zähigkeit und hoher Entlötetemperatur, gegenüber den bleihaltigen Loten schließen können.

Im Stand der Aufbau- und Verbindungstechnik sind Konzepte bekannt, bei denen man versucht durch das Einlegen von Formkörpern, Netzen oder Ringen ein Verkippen der zu lötenden Bauteile beim Lötvorgang zu unterbinden und konstante Lotschichtstärken zu erzeugen. Nachteilig, bei diesen Verfahren ist, dass Gaseinschlüsse, die zu lunkerbehafteten Lötverbindungen führen, nicht auszuschließen sind.

So wurde in der DE 2228703 A1 bzw. der korrespondieren US 3900153 A ein Lotmaterial vorgestellt, bei dem metallische, runde oder zylindrische Partikel in das sie umgebende Weichlot im Schmelzverfahren eingerührt, oder durch Walzen mit dem Ziel eingebracht werden, einen gleichbleibenden Abstand zwischen den zu verlötenden Teilen eines elektrischen Bauelementes zu gewährleisten um ein Verkippen der zu lötenden Bauteile beim Lötvorgang zu unterbinden.

Die bei dieser Lösung in das Lotmaterial eingebrachten metallischen Partikel dürfen beim Lötvorgang nicht schmelzflüssig werden, um nach dem Lötvorgang einen minimalen Abstand zwischen den Bauteilen zu gewährleisten.

Mit dieser Lösung kann, da die Partikel geometrisch-willkürlich und keinesfalls reproduzierbar im Weichlotmaterial integriert sind, allenfalls eine, an die Höhe der Partikel geknüpfte, minimale Mindestschichtdicke nach dem Verbinden der Bauteile eingestellt werden.

Sowohl beim Einrühren der Partikel im Schmelzverfahren in das sie umgebende Weichlot wie auch beim Einwalzen der Partikel in Weichlotfolien oder Weichlotbänder entstehen schwerwiegende Nachteile für die mit solchem Material nachfolgend gelöteten Bereiche, welche vor allem durch eine erhöhte Anzahl an Kavitäten in der Verbindungsstelle gekennzeichnet sind.

In der JP 2004174522 A wird ein anderes bleifreies Verbundlot und sein Herstellungsverfahren vorbeschrieben.

Für den Einsatz dieses bleifreien Verbundlotes nach der JP 2004174522 A ist die Ausübung einer Presskraft während des Lötprozesses, d.h. die Beaufschlagung der Fügestelle mit einem Gewicht, zwingend erforderlich. Dadurch ist dieser Fügeprozess einerseits mit einem hohen fertigungstechnischen Aufwand verbunden, andererseits kann diese zwingend erforderliche Presskraft, da die Halbleiterbauelemente heute immer dünner werden, zu einer Beschädigung bis hin zum Bruch der Halbleiterbauelemente führen und dadurch zum Verlust der elektrischen Eigenschaften der zu verlötenden Bauelemente zur Folge haben.

Bei dem in der JP 2004174522 A vorbeschriebenen Verbundlot kommen stets Metallnetze zum Einsatz, in denen u.a. Kupferdrähte mit einem Drahtdurchmesser von 25 µm bis 100 µm maschenförmig miteinander verwebt sind, wobei diese Cu-Kupferdrähte entweder vor dem Fügen mit den Weichlotfolien kostenintensiv in Vakuum oder unter inerten Argon-Gas bei etwa 400°C bis 600°C über 30 Minuten lang gereinigt, oder vor dem Fügen mit den Weichlotfolien mit einer Schichtdicke von ca. 1 µm mit Zinn beschichtet werden müssen.

Diese gereinigten oder mit Sn beschichteten Netze werden dann, ein oder auch mehrfach, jeweils zwischen zwei Lotfolien aus Zinn, mit einer Foliendicke von jeweils 20 µm bis 250 µm, sandwichartig übereinander geschichtet, und nachfolgend entweder, in einem sehr unwirtschaftlichen Verfahren, diskontinuierlich durch Verbundpressen, oder effektiver, kontinuierlich durch Walzplattieren, bei einer "prozentualen Höhenreduktion" aller sandwichartig übereinander geschichteten Bestandteile des Verbundlotes, d.h. die Lötfolien und das/die Netz/e, (ermittelt aus der Differenz zwischen der summarischen Ausgangshöhe aller sandwichartig übereinander geschichteten Bestandteile des Verbundlotes und der Endhöhe bezogen auf die summarische Ausgangshöhe aller sandwichartig übereinander geschichteten Bestandteile des Verbundlotes in %) von 20% bis 30% zu einem Verbundlot verpresst. Gemäß den in Verbindung mit der JP 2004174522 A eingesetzten Fügeverfahren, kann aufgrund der komplexen Geometrie der metallischen Netze insbesondere im Bereich der Knüpfungspunkte, unter den gegebenen Prozessbedingungen (bei einer Höhenreduktion von 20% - 30%) ein vollständiges stoffschlüssiges Umfließen der Drahteinlagen durch die umgebende Weichlotmatrix nicht gewährleistet werden (Verweis auf JP 2004174522 A, Figuren 5 und 6). Daher verbleiben in den schwer erreichbaren Zwischenräumen im Bereich der Knüpfungspunkten der Netze Hohlräume. Zudem berühren sich die Weichlotfolien unter den angegebene Prozessbedingungen im Bereich der Maschenweiten allenfalls leicht. Es kann aber unter den in der JP 2004174522 A vorgeschlagenen Prozessbedingungen keine haftfeste, stoffschlüssige Verbindung zwischen den Einsatz findenden Sn-Folien hergestellt werden.

Daher sind die, mittels dieser im JP 2004174522 A vorbeschriebenen Lösung, im Sn-Lot angeordneten Metallnetze nur mit geringer Haftfestigkeit im Sn-Lot integriert und weisen zudem gleichzeitig viele Kavitäten/Lunker auf.

Weder durch das Verzinnen der Metallnetze, noch durch das Pressen oder das Walzplattieren können beispielsweise die Spalte zwischen den Drahtknüpfungspunkten des metallischen Gewebes mit Weichlot geschlossen werden.

Die im Verbundlot der Lösung nach der JP 2004174522 A eingebetteten Gasblasen, welche sich vorzugsweise in den Drahtknüpfungspunkten sammeln und dort fixiert werden, lassen sich beim Weichlöten selbst unter Vakuum nur in sehr geringem Umfang entfernen.

Daher verbleibt bei Einsatz dieser Lotfolie nach der JP 2004174522 A ein hoher Anteil an Porosität (selbst nach einem kostenintensiven Lötprozess unter Vakuum) in der Verbindungsschicht.

Diese Gaseinschlüsse beeinträchtigen auf Grund der isolierenden Wirkung der Gaseinschlüsse zwangsläufig die thermische Leitfähigkeit so, dass die thermische Leitfähigkeit einer nach der JP 2004174522 A gefügten Fügestelle auch hinter der thermische Leitfähigkeit eines monolithischen Lotes zurückbleibt.

Weitere Nachteile resultieren auch daraus, dass bei den zu integrierenden Metallnetzen die Knüpfungspunkte, mit ihren doppelten Drahtdicken zwangsläufig stets unmittelbar neben nicht überlappten, einfachen Drahtabschnitten zu liegen kommen, und beide dabei auch zugleich noch neben Maschenhohlräumen liegen.

Beim Einpressen der Weichlotfolien in diese Gitterstrukturen der Metallnetze haben die eingesetzten Weichlotfolienwerkstoffe, unmittelbar nebeneinander daher auch völlig unterschiedlich hohe dem Stofffluss entgegenstehende Umformwiderstände zu überwinden, woraus sich lokal unmittelbar dem stoffschlüssigen Haftungsaufbau entgegenstehende, d.h. unförderliche, Spannungszustände (Scherspannungen, Zugspannungen) zwischen den Verbindungspartnern ergeben.

Hinzu kommt, dass bei der im JP 2004174522 A vorgeschlagenen prozentualen Höhenreduktion von 20% bis 30%, sich die Verunreinigung der Bandoberflächen zwischen den zum Verbundlot verpressten Bändern ansammeln, und beim Löten dann zu minderwertigen Lötstellen führen.

All diese bereits erläuterten Nachteile der in der JP 2004174522 A Lehre haben zudem zur Folge, dass die in Wirkverbindung tretenden Fügepartner, d.h. die Metallnetze und die Sn - Folien, bei mechanischer Beanspruchung des Verbundes zu einem "Ablösen" voneinander neigen.

Bereits geringste mechanische Beanspruchungen in den nachfolgenden Bearbeitungsschritten der Verbundfolie, wie beispielsweise die Scherkräfte beim Stanzen der Folien, führen daher zu einem Delaminieren der Komponenten, d.h. einerseits zu einem Delaminieren der Netze von den Folien, aber andererseits auch zum Ablösen der Zinnfolien voneinander.

Dies hat dann zwangsläufig sehr hohe und auch kostenintensive Ausschussraten zur Folge.

Zwar kann der Nachteil der zu geringen Haftfestigkeit zu Lasten der ebenfalls erwünschten erhöhten Wiederaufschmelztemperatur abgemildert werden, indem man sich beispielsweise darauf beschränkt, nur dicke Weichlotfolien mit dünnen Drahtgeflechten zu kombinieren.

Die Lehre nach der JP 2004174522 A schlägt daher unter anderem auch vor, den Nachteil der verbleibenden Hohlräume, bzw. der Bereiche die nicht mit Weichlot umflossen sind, zu Lasten der erhöhten Wiederaufschmelztemperatur abzumildern, indem man vorsieht dicke Weichlotfolien mit dünnen Drahtgeflechten zu kombinieren damit mehr Drahtbereiche mit Weichlot umflossen werden.

Doch eine derartig aufgebaute Lotfolie kann dann keinesfalls mehr den ebenfalls in der JP 2004174522 A beschriebenen Effekt des Aufbaus intermetallischer Phasen mit einer erhöhten Wiederaufschmelztemperatur gewährleisten, da die Auflagen an Weichlot auf den Metallnetzen für eine Anbindung über intermetallische Phasen an die Fügepartner beim Löten schlicht zu hoch sind.

Daher geht bei dieser Lösung nach der JP 2004174522 A eine zwar mögliche Erhöhung der von Weichlot umflossen Drahtoberfläche der Drahtgeflechte in der Weichlotmatrix zwingend mit einem deutlichen Absinken der für sichere Stufenlötprozesse erwünschten hohen Wiederaufschmelztemperatur, infolge der fehlenden Anbindung der Metallnetze über intermetallische Phasen an die Fügepartner einher.

Da eine erhöhte Wiederaufschmelztemperatur und mechanisch langlebigere Verbindungen mit der in der JP 2004174522 A vorgestellten Lösung jedoch nur dann gewährleistet werden können, wenn sich zwischen den Metallnetzen und den Fügepartnern intermetallische Phasen aufbauen, sind zwingend relativ geringe Schichtdicken von Weichlot zwischen den Kupferdrähten und den Fügepartnern erforderlich, da nur unter diesen Rahmenbedingungen mit dem Netzwerkstoff der Metallnetze, dem Cu intermetallische Phasen ausgebildet werden.

Auf Grund der sehr großen Oberfläche des in der JP 2004174522 A Einsatz findenden Cu-Gewebes werden jedoch die intermetallische Phasen dann in einem so großem Volumenumfang in den Lötstelle gebildet, dass die Lötstellen verspröden, da nach dem Lötprozess zu wenig duktiles Weichlot verbleibt, welches die Kompensation der beim Lötprozess auftretenden thermomechanischen Spannungen, die aus den unterschiedlichen thermischen Ausdehnungskoeffizienten der an der Fügeverbindung beteiligten Bauelemente/Materialien resultieren, übernehmen könnten. Dies hat zur Folge, dass dann die schwächsten Fügepartner, hier die elektronischen Bauteile, brechen.

Bei Lotverbindungen mit einem sehr hohen Anteil an intermetallischen Phasen hat man das Problem, dass nur Substrate mit elektrischen Bauteilen gefügt werden können, die keine zu große Differenz in den thermischen Ausdehnungskoeffizienten zueinander haben, da sonst Scherspannungen im Halbleiter einen Bruch des Halbleiters beim Löten herbeiführen können, da kein duktiles Weichlot in der Lot-Verbindung zur Verfügung steht, dass diese Spannungsspitzen/ Spannungsüberhöhungen aufnehmen könnte. Bei für die thermomechanische Beanspruchung günstigen Lot-Verbindungen, die vorzugsweise komplett aus Weichlot bestehen, welches die thermischen Spannungen beim Löten durch Verformung aufnimmt, hat man die Probleme eine hochtemperaturbeständige Lotverbindung zu erzielen, die eine hohe thermische Zuverlässigkeit der Verbindungszonen zwischen den benachbarten Bauteilen auch in Stufenlötprozessen gewährleistet.

In diesem Zusammenhang wird in der JP 2004174522 A darauf verwiesen, dass die optimale Dicke des Verbundlotes 150 µm beträgt, und es bis zu einer Dicke von 250 µm eingesetzt werden kann, da bei Dicken des Verbundlotes von 250 µm und mehr der elektrische und thermische Widerstand der Verbindungstelle zu groß wird, so dass dann beispielsweise die Temperatur nicht mehr ausreichend von den elektronischen Bauteilen abgeführt werden kann.

In der JP 2004174522 A wird auch festgestellt, dass ab einer Dicke des Verbundlotes von 80 µm und weniger der Spannungsabbau nicht mehr gewährleistet werden kann, wodurch dann Risse auftreten.

Dies resultiert daraus, dass nach der JP 2004174522 A unter Einsatz von einem oder mehreren Drahtgeflechten die Weichlotschicht großflächig durch den Draht und/oder den beim Löten gebildete Intermetallischen Phasen vermindert wird, so dass nach dem Lötprozess überall verteilt nur dünne Bereiche aus "Restweichlot" verbleiben.

Da mit dem nach der Lehre der JP 2004174522 A hergestellten Materialverbund eine definierte Geometrie des Drahtgeflechts sehr schwer zu gewährleisten ist, kann mit diesem Materialverbund eine exakte Ausbildung der Lötstelle, insbesondere bei geometrisch komplexen Formräumen, nicht gewährleistet werden, da der minimale Abstand nur über die periodisch wiederkehrende Drahtknüpfungspunkte definiert werden kann.

In der WO 2011/112722 A1 wird ein weiteres Material zum Diffusionslöten vorbeschrieben. Dieses Material besteht aus einem metallischen Trägerband und einer dünnen, bleifreien, beidseitigen Weichlotauflage, welche bei einem zeitintensiven Lötvorgang möglichst vollständig in intermetallische Phasen umgewandelt wird. Wie in der Patentschrift WO 2011/112722 A1 ausgeführt, ist zudem stets zu berücksichtigen, dass stets Werkstoffe mit zumindest ähnlichen Wärmeausdehnungskoeffizienten gefügt werden.

Dies stellt neben dem zeitintensiven Lötprozess eine wesentliche Einschränkung beim Fügen von klassischen, siliziumbasierten Halbleiterbauelementen dar, die dann nur auf Substrate gelötet werden können, die eine das Missverhältnis aus den unterschiedlichen Wärmeausdehnungskoeffizienten der unterschiedlichen Materialien kompensierende Keramikzwischenschicht besitzen, bekannt als AMB (Active metal brazed), DCB (Direct copper bonded) oder DBC (Direct bonded copper), so dass nur diese teuren Keramiksubstrate als Materialien für den Einsatz in Frage kommen. Wie in der WO 2011/112722 A1 ebenfalls dargelegt, müssen die zu fügenden Oberflächen in Bezug auf Rauheit, Welligkeit und Ebenheit, zudem auch gesondert vorbereitet werden, um eine ausreichende Benetzung zu gewährleisten.

Aus der von der Anmelderin hinterlegten DE 10 2017 004 626 A1, bzw. der korrespondierenden WO 2018 /210361 A1 ist weiterhin eine bewährte bleifreie Lötfolie zum Diffusionslöten und ein Verfahren zu deren Herstellung bekannt, mit welcher metallische Bauteile und/oder metallisierte/metallbeschichtete Bauteile, d.h. metallische Oberflächenschichten zu verlötendender, benachbarter Bauteile, in einem für das Weichlöten typischen Prozesstemperaturgebiet und in Lötzeiten von unter 5 min, ohne eine anschließende Wärmebehandlung und ohne die Ausübung einer Presskraft während des Lötens, so miteinander verbunden werden können, dass eine durchgängige Schicht einer hochschmelzenden Verbindungszone in Form einer intermetallischen Phase mit einer Wiederaufschmelztemperatur von höher als 400°C entsteht.

Die in dieser Lehre offenbarte, bleifreie Lötfolie zum Diffusionslöten beinhaltet einen Lotverbundwerkstoff der durch Walzplattieren so hergestellt wird, dass in einer bleifreien Weichlotumgebung einer Weichlotmatrix ausschließlich kompakte Partikel einer hochschmelzenden Metallkomponente vollständig im bleifreien Weichlot derart eingebettet sind, das diese in der Weichlotmatrix dispers verteilten Partikel der hochschmelzenden Metallkomponente in Richtung der Folienstärke eine Dicke von 3 µm bis 20 µm aufweisen, wobei die Abstände der Partikel zueinander in der Weichlotmatrix 1 µm bis 10 µm betragen, und jeder der Partikel der hochschmelzenden Metallkomponente allseitig von einer 1 µm bis 10 µm starken Schicht des bleifreien Weichlotes umhüllt ist, und diese Lötfolie zudem eine den metallischen Oberflächenschichten der zu fügenden Bauteile benachbarte äußere Mantelschicht aufweist, deren Schichtdicke 2 µm bis 10 µm beträgt und die aus Weichlot besteht.

Mittels dieser bleifreien Lötfolie kann zwar eine sichere, kostengünstige bleifreie Auslegung von Stufenlötungen gewährleistet werden, jedoch ist mittels dieser Lösung keine geometrische Kontrolle der Lotschicht, insbesondere den Fall einer komplexeren Geometrie für einen Lötspalt betreffend, möglich um beispielsweise ein Verkippen der zu lötenden Bauteile beim Lötvorgang zu unterbinden.

Aus der in der DE 10 2013 110 812 B3 offenbarten Lehre ist, ebenso wie aus einer Variante der in der DE 2228703 A1 bzw. der korrespondieren US 3900153 A offenbarten Lehre bekannt, höherschmelzende Partikel auf die Oberfläche von Lotbändern aufzugeben und diese anschließend durch Walzen oder Linearpressen in die Oberflächen der Bänder einzudrücken, um auf diese Weise einen Lötwerkstoff zu erzeugen, der wiederum höherschmelzende Partikel enthält, welche dann nach dem Löten eine homogene Lotschichtdicke gewährleisten sollen.

Dieses Herstellungsverfahren des Einwalzens bzw. Einpressens führt, bei dieser Lösung, wie bei der zuvor erläuterten Lösung auch, zu gravierenden Nachteilen, da durch das Einwalzen oder Einpressen nur schwache Bindungskräfte zwischen den Partikeln und dem Weichlotmaterial erzeugt werden.

Bei dem durch das Einwalzen oder Einpressen hergestellten losen Verbund besteht permanent die Gefahr, dass die höherschmelzenden Partikel entweder beim Transport, oder bei sonstigen Manipulationen bereits vor dem Lötprozess, durch Herab- oder Herausfallen verloren gehen.

Zudem werden die Oberflächen der Partikel erst dann mit Lot benetzt, wenn diese in das flüssige Lot einsinken, was je nach Menge/ Anzahl und Art des Materials zu Gaseinschlüssen führt, die zwangsläufig zu lunkerhaften Lötverbindungen führen die eine nicht unerhebliche Schwächung der Verbindungsstelle aufgrund von Benetzungsfehlern zur Folge hat.

Andere Lösungen wie beispielsweise die in der DE 3442537 A1 beschriebene Lösung, verwenden metallische Gewebe oder strukturierte Folien aus höherschmelzenden Metallen (Schmelztemperatur dieser metallischen Gewebe oder strukturierten Folien ist höher als die des beteiligten Weichlotes) um eine möglichst einheitliche Dicke der Lotstellen zu gewährleisten.

Dabei werden diese metallischen Gewebe oder strukturierten Folien vor dem Löten entweder unter oder über dem Weichlot platziert.

Ebenso ist bekannt, solche Netze zwischen die Aufbauten zu legen und mit Lotpaste zu füllen.

Ein wesentlicher Nachteil der separaten Aufbringung der Netze und strukturierten Folien ist, dass diese beim Lötvorgang vom Lot infiltriert werden müssen, bzw. diese mit zumindest einer zu fügenden Bauteiloberfläche initial in Kontakt stehen und dadurch eine Benetzung durch das Lot verhindern.

Die Lötprofile müssen für diese Einsatzfälle so ausgelegt werden, dass die thermischen Massen der Netze und Folien mit einkalkuliert werden, was einen nicht unerheblichen Aufwand für die Erstellung von neuen Lötprofilen bedeutet, die zudem dann auch längere Lötzeiten gegenüber den (im Stand der Technik üblichen) herkömmlichen Weichlötprofilen erfordern.

Bei jeder Neuauslegung einer Lötstelle muss das Lötprofil neu angepasst werden.

Dabei muss zwingend die Zeit der Infiltration durch den Lotwerkstoff bedacht, und auch die Zeit für ein Absinken des Netzes bzw. der profilierten Folien im schmelzflüssigen Lot einkalkuliert werden.

Zudem besteht dabei stets die Problematik der Auslegung der Dicke der Netze und Folien im Vergleich zur Dicke der Lotschicht.

Je nach Komplexität der Netze und Folien müssen sehr niedrigviskose Lote gewählt werden.

Zudem muss der Dichteunterschied zwischen dem Material des Netzes und dem Material des Lotes berücksichtigt werden, um ein Absinken/Einsinken des Netzes ins flüssige Lotmaterial zu gewährleisten. Häufige Folge dabei sind Benetzungsfehler, die dann die thermische Leitfähigkeit verringern sowie die mechanische Stabilität der Lotschicht und damit die Zuverlässigkeit einer so erzeugten Lötstelle deutlich beeinträchtigen/reduzieren.

Da die Netze oder strukturierten Folien nicht in einem Preform (Lotformteil) integriert sondern lose beim Aufbau des Stacks eingelegt werden, erfordert dies einen separaten Bestückungsschritt, dies erhöht zwingend zudem auch deutlich die gesamte Fertigungszeit des Lötprozesses.

Aus der WO 2018/209237 A1 ist ein Lotmaterial bekannt, bei dem Weichlotbändern durch Einschmelzen oder Einwalzen Drähte mit einem Durchmesser von 5 µm bis 200 µm zugeführt werden, mit dem Ziel die thermische Leitfähigkeit der durch diesen Werkstoffverbund hergestellten Lötstelle zu erhöhen.

Mit dem in der WO 2018/209237 A1 nicht näher beschriebenen, aber mit Schlagworten erfasste Herstellverfahren des Materials, gemäß dem von einem Einwalzen des Drahtes in Bänder oder Folien ausgegangen werden muss, liegen die Oberflächenbereiche des Drahtes offen an der Oberfläche des Verbundes vor.

Durch Einwalzen kann keine wirklich feste, stoffschlüssige Integration des Drahtes im Weichlotband erzielt werden.

Dadurch besteht bei den Folgebearbeitungsschritten, wie Stanzen oder Biegen stets die Gefahr, dass der Draht vor dem Löten aus dem Weichlot "herausgelöst" wird.

Zudem bedeutet dies, das der Draht beim Löten zunächst im flüssigen Weichlot absinken/einsinken muss, was Hohlstellen und Benetzungsfehler mit sich bringt.

Daher treten auch bei dieser Lösung die bereits beschriebenen, allen bisher zitierten Lösungen gemeinsamen Nachteile auf, die darin bestehen, dass auch in dem nach der WO 2018/209237 A1 gefertigten Lotmaterial stets kleine mit Atmosphäre gefüllte Spalte, Kavitäten oder ähnliches verbleiben, die beim Löten zu Lunkern und Poren mit den bereits erläuterten Nachteilen führen. Das in der WO 2018/209237 A1 ausgewiesenen Material/Lotformteil kann aber auch dadurch erzeugt werden, dass der Draht dem schmelzflüssigen Lot zugegeben wird.

Dabei geht (bei üblichen Draht-/Weichlotkombinationen (Draht aus Kupfer, Zinnbasis-Weichlot)) bereits vor dem Löten ein nicht unbeträchtlicher Teil des Drahtes im flüssigen Weichlot in Lösung,

Ein derartiges Herstellverfahren bei dem der Draht dem schmelzflüssigen Lot zugegeben wird ist zudem sehr fertigungsintensiv, da hierfür nur diskontinuierliche und qualitativ minderwertige Urformverfahren, wie Barrenguss und keine kontinuierlichen Verfahren wie Strangguss in Frage kommen können.

Das in der WO 2018/209237 A1 beschriebene Material, soll neben der Erhöhung der thermischen Leitfähigkeit auch den positiven Nebeneffekt besitzen die Lotschichtdicken beim Lötvorgang zu kontrollieren.

In diesem Zusammenhang ist festzustellen, dass gemäß dem heutigem Stand der Technik die Lötstellen eines Leistungshalbleitermoduls zwischen der Bodenplatte bzw. dem Kühler und dem Substrat, aus Gründen der thermomechanischen Langzeitstabilität, zu Lasten der Erhöhung des Wärmewiderstandes, mit Dicken/Lotschichtstärken beginnend ab 250 µm bis ca. 400 µm ausgeführt werden.

Für diese im Stand der Technik üblichen Lotschichtstärken von 250 µm bis ca. 400 µm ist das in der WO 2018/209237 A1 beschriebene Material gemäß völlig ungeeignet, da selbst bei einem Drahtdurchmesser von 200 µm die Bauteile zueinander noch um mindestens 50 µm (bei einer Lotschichtdicke von 250 µm) bis maximal 200 µm (bei einer Lotschichtdicke von 400 µm) Verkippen könnten. Im letzten Fall also um 50% der Dicke der vorgesehenen Lotschichtstärke. Durch dieses "Verkippen in der Lötstelle" wird jedoch das durch das Einbringen der Drähte angestrebte Ziel (die Aufgabe) der Erfindung, die Erhöhung der thermischen Leitfähigkeit der Lötstelle, zunichte gemacht, da verkippte Lotstellen die Hauptursache für die Ausbildung von thermischer Hotspots sind. Grundsätzlich ist zudem festzustellen, dass eine für die thermomechanische Beanspruchung günstige Lot-Verbindung einerseits in einem bestimmten Umfang höhertemperaturstabilen intermetallischen Phasen mit darin eingeschlossen höherschmelzendes Metall (aus Cu oder ähnlichem) enthalten sollte, zudem gleichzeitig aber auch noch duktil, kriechbeständig, d.h. unempfindlich gegenüber thermischen Lastwechseln sein sollte.

Aufgabe der Erfindung ist es daher, eine bleifreie Lötfolie mit einer Dicke von 50 µm bis 600 µm zu entwickeln, welche das Einstellen einer definierten und reproduzierbaren Verbindungszonengeometrie, ob einfacher oder aber auch komplexer Gestalt auch nach dem Lötprozess ermöglicht, wobei der Lötprozess auch in einem für das bleifreie Weichlöten typischen Prozesstemperaturgebiet d.h. bei vorzugsweise von 250 bis 300°C, aber mindestens 20-30 K über den Liquidustemperaturen der verwendeten Weichlote und mit dem im Stand der Technik für das bleifreie Weichlöten typischen üblichen Lötzeiten von unter 5 min, wie auch ohne eine anschließende Wärmebehandlung und auch ohne die Ausübung eines zusätzlichen Anpressdruckes auf die Fügepartner während des Lötens, sowie unabhängig von den beim Löten einzustellenden Atmosphären im Lötofen erfolgen kann, wobei bei minimalster Ausbildung von Poren und/oder Lunkern in der Verbindungszone, eine hochtemperaturbeständige Lotverbindung erzielt werden soll, und die eine hohe thermische Zuverlässigkeit der Verbindungszonen zwischen den benachbarten Bauteilen auch in Stufenlötprozessen, bei denen die Gefahr eines Wiederaufschmelzens zuvor gelöteter Bereiche besteht, gewährleisten soll, und die zudem eine in den geometrischen Abmessungen hochgenaue, geometrisch exakte Verbindungszone gewährleistet, welche zudem die thermische Leitfähigkeit der gesamten Verbindungszone deutlich verbessert und gleichzeitig einen Rissfortschritt in der Verbindungszone bei Materialermüdung unterbindet / aufhält, und dabei zugleich die durch das Löten eingebrachte, aber auch die während des Bauteileinsatzes entstehenden thermischen Spannungen auf Grund Ihrer Duktilität aufnimmt, und dadurch im Wirkgesamtzusammenhang mittels der hier vorgestellte Lösung die Lebensdauer der Verbindungszone, gegenüber einer mit Lötmaterialien nach dem Stand der Technik der Aufbau- und Verbindungstechnik hergestellten Verbindungszone, um ein Vielfaches erhöht.

Erfindungsgemäß wird diese Aufgabe durch eine bleifreie Lötfolie (1) mit einer Dicke von 50 µm bis 600 µm gelöst, mit der metallische Bauteile und/oder metallisierte/metallbeschichtete Bauteile, d.h. metallische Oberflächenschichten benachbarter Bauteile, in neuartiger Weise selbst in einem Lötprozess, bei/in einem für das bleifreie Weichlöten typischen Prozesstemperaturgebiet d.h. bei vorzugsweise von 250 bis 300°C, aber mindestens 20-30 K über den Liquidustemperaturen der verwendeten Weichlote, und mit dem im Stand der Technik für das bleifreie Weichlöten typischen üblichen Lötzeiten von unter 5 min, wie auch unabhängig von den beim Löten einzustellenden Atmosphären im Lötofen, bei minimalster Ausbildung von Poren und/oder Lunkern in der Verbindungszone, eine hochtemperaturbeständige Lotverbindung erzielt wird, die eine hohe thermische Zuverlässigkeit der Verbindungszonen zwischen den benachbarten Bauteilen auch in Stufenlötprozessen, bei denen die Gefahr eines Wiederaufschmelzens zuvor gelöteter Bereiche besteht, gewährleistet, so dass auf Grund der erfindungsgemäßen Eigenschaften der mit der Lötfolie zu gewährleistenden neuartigen Lotverbindung die vorgenannten Probleme des Standes der Technik gelöst und aufgrund des erfindungsgemäß möglichen Layouts komplex-geometrische Aufbauten, wie sie zukünftig auch insbesondere bei Stacks mit integrierter mechatronischer Funktion zu finden sein werden, möglich sind.

Wesentlich ist auch, dass die erfindungsgemäße Lötfolie (1) bei Bedarf weder eine anschließende Wärmebehandlung noch die Ausübung eines zusätzlichen Anpressdruckes auf die Fügepartner während des Lötens erfordert. Erfindungswesentlich ist dabei, dass die Lötfolie (1) kompakt so aufgebaut ist, dass in einer Weichlotmatrix (2), die entweder aus bleifreien Zinnbasisloten, reinem Zinn, reinem Indium oder aus Legierungen auf Basis von Indium, wie InSn48 besteht, zwei oder mehr Verbunddrähte (3) jeweils einzeln, parallel zueinander und parallel zu den Bandkanten, dadurch integriert sind, dass die Verbunddrähte (3) längs zur Walzrichtung ausgerichtet zwischen zwei Weichlotfolien oder zwei Weichlotbändern mittels Walzplattieren bei einer "prozentualen Höhenreduktionen der Ausgangsbänder", ermittelt aus der Differenz zwischen der summarischen Ausgangshöhe der Bänder (6) (ermittelt ohne Hinzurechnung der Höhe der Verbunddrähte (3)) und der End-Höhe (H) der Verbundfolie (1) (mit eingebetteten Verbunddrähten (3)) bezogen auf die summarische Ausgangshöhe der Bänder (6), in %, im Bereich von größer 30 % bis maximal 95 %, vorzugsweise von 50 bis 85 % einplattiert und dadurch stoffschlüssig in der Weichlotmatrix angeordnet werden.

Wesentlich ist auch, dass der minimal zulässige Abstand zwischen den Kernen (4) der Verbunddrähten (3) nach dem Walzprozess ca. 500 µm beträgt. Dadurch wird bewirkt, dass noch in genügend ausreichendem Maße duktiles Weichlotvolumen zwischen den mit intermetallischen Phasen ummantelten Drähten verbleibt, um die beim Löten und im Einsatzfall auftretenden thermo-mechanischen Spannungen, resultierend aus den unterschiedlichen Wärmeausdehnungskoeffizienten der Fügepartner, durch elastisch-plastische Deformation ausgleichen zu können.

Gleichzeitig besteht bei diesem Abstand keine Gefahr das die beim Löten unter reaktiven Atmosphären gebildeten Reaktionsprodukte aufgrund von Kapillaritätseffekten im Weichlotvolumen zurückgehalten werden. Kennzeichnend ist weiterhin, dass der minimal zulässige Abstand der Kerne (4) der Verbunddrähte (3) zum Außenrand der Lötfolie nach dem Walzprozess ca. 500 µm beträgt.

Dadurch wird bewirkt, das die beim Walzplattierprozess im Bereich der Bandkanten auftretenden Zugspannungen keinen negativen Einfluss auf die stoffschlüssige Integration der Verbunddrähte (3) haben und evtl. dadurch auftretende Haftungs- oder Bindungsfehler im Lötfall zu einer erhöhten Porosität oder Lunkerbildung führen könnten.

Die maximalen Abstände der Kerne (4) der Verbunddrähte (3) untereinander und zum Außenrand der Lötfolie nach dem Walzprozess hängen dabei jeweils von der Breite der Einsatz findenden Weichlotbänder ab. Dadurch wird bewirkt, das je nach Anwendungsfall die Anzahl an Verbunddrähte (3) und deren genaue Positionierung über die Breite der Bänder (6) innerhalb der zuvor genannten Einschränkungen und Grenzen sehr flexibel und individuell ausgeführt werden kann und damit für alle gängigen Aufgaben der Aufbau und Verbindungstechnik eine spezifische Lösung realisiert werden kann.

Mittels dieser erfindungsgemäßen Lotfolie, in der jeweils einzeln und parallel zu den Bandkanten, längs zur Walzrichtung ausgerichtete Verbunddrähten (3) parallel zueinander komplett stoffschlüssig, d.h. mit einer maximalen Haftfestigkeit fest in der Weichlotmatrix (2) integriert sind, wird gewährleistet, dass die in den nachfolgenden Bearbeitungsschritten, beispielsweise beim Stanzen der Folien, auftretenden Kräfte keinesfalls ein Delaminieren der Komponenten zur Folge haben.

Zugleich bewirkt die erfindungsgemäße, komplett stoffschlüssig Integration der Verbunddrähten (3) in der Weichlotmatrix (2), dass nach dem erfindungsgemäßen Walzplattieren mit einer "prozentualen Höhenreduktionen der Ausgangsbänder" im Bereich von über 30 % bis 95 %, im Innern des Verbundes, keinerlei Kavitäten verbleiben, so dass dann im Lötprozess aus der erfindungsgemäßen Lötfolie (1) auch keine Gase mehr entfernt werden müssen, wodurch das Weichlot der Weichlotmatrix (2), in der erfindungsgemäßen Lötfolie (1), stets die selben technischen Eigenschaften wie das monolithische Ausgangs-Weichlotmaterials aufweist.

Wesentlich ist aber auch, dass die jeweils einzeln in der Lötfolie (1) angeordneten Verbunddrähte (3) einen Kern (4) aufweisen der aus einem gegenüber der Weichlotmatrix (2) höherschmelzenden und zugleich festeren Metall, oder einer Metalllegierung, wie aus Kupfer oder einer Kupferbasislegierung, Silber oder Silberbasislegierungen, Nickel oder Nickelbasislegierungen, Gold oder Goldbasislegierungen besteht, um den herum ein Mantel (5) aus einem anderen Metall oder einer anderen Metalllegierung, wie aus reinem Zinn oder einer Zinnbasislegierung, oder aus Indium oder einer Indiumbasislegierung angeordnet ist.

Kennzeichnend ist dabei, dass der Mantel (5) der Verbunddrähte (3) bezogen auf den Gesamtdurchmessers des Verbunddrahtes (3) eine Schichtdicke von 2% bis 20% aufweist.

Ein weiteres wesentliches Merkmal der Erfindung besteht auch darin, dass nach dem Walzplattiervorgang, über und unter mindestens einem der Kerne (4) der in der Weichlotmatrix (2) einplattierten Verbunddrähte (3), noch eine Schicht aus Weichlotmaterialien angeordnet ist, welche sich aus dem Bereich der Weichlotmatrix (2) und der Schicht aus dem Mantel (5) der Verbunddrähte (3) zusammensetzt, die in Summe dann an der dünnsten Stelle mindestens 5 µm aber maximal 15 µm, vorzugsweise 5 µm bis ca. 10 µm beträgt.

Die erfindungsgemäße Lötfolie (1) wird erzeugt, indem ein oberes Band (6) aus Weichlot, ein unteres Band (6) aus Weichlot, sowie mehrere zwischen den Bändern (6) liegende Verbunddrähte (3) definiert einem Walzspalt zum Walzplattieren zugeführt werden.

Durch die die Formänderungen zur Querschnittsreduzierung bewirkenden Kräfte wird bewirkt, dass die einzelnen Bestandteile der erfindungsgemäßen Lötfolie (1) stoffschlüssig miteinander zu einem Werkstoffverbund gefügt werden.

Der aus diesem Walzplattierprozess resultierende Werkstoffverbund in Form der erfindungsgemäßen Lötfolie (1) hat, quer zur Bandlänge der Lötfolie (1) beispielsweise das Aussehen eines Rechteckquerschnittes in dessen Weichlotmatrix (2) die Verbunddrähte (3) stoffschlüssig eingebettet sind. Mittels der Auslegung der Werkstoffe und der Drahtgeometrien der Verbunddrähte (3), welche im Ausgangszustand einen runden oder ovalen Querschnitt aufweisen können, in Verbindung mit der speziellen Wahl für die Geometrie der Bänder im Ausgangszustand im Zusammenwirken mit der Einstellung der Geometrie des Walzspaltes, kann eine Vielzahl an komplexen geometrischen Anordnungen für das Innere der Lötfolie erzeugt werden (nachfolgend als Layout bezeichnet). Durch das erfindungsgemäße Walzplattieren wird jedoch zunächst generell stets ein Flachprodukt, was in erster Näherung einer Vieleckgeometrie entspricht, erzeugt.

Der Abstand der einzelnen Verbunddrähte (3) untereinander wie auch die Walzspaltgeometrie selbst ist dabei stets definiert und reproduzierbar einstellbar.

Da als Ausgangsprodukte "Quasi-Endloshalbzeuge" in Form von Weichlotfolien oder Weichlotbändern und Verbunddraht eingesetzt werden, ist das Herstellungsverfahren der erfindungsgemäßen Lötfolie (1) sehr effektiv und wirtschaftlich.

Mit der erfindungsgemäßen Lötfolie (1) liegt ein Verbund vor, bei dem alle Materialien komplett stoffschlüssig gefügt werden und keine mit Atmosphäre gefüllten Spalte, Kavitäten oder ähnliches verbleiben.

Damit wird ein Herausfallen oder Verrutschen oder sonstige Delokalisation der Verbunddrähte, beim Transport der erfindungsgemäßen Lötfolie oder bei sonstigen Manipulation mit der erfindungsgemäßen Lötfolie, vollständig ausgeschlossen.

Dadurch, dass erfindungsgemäß nur runde oder ovale VerbunddrahtQuerschnitte als Halbzeug eingesetzt werden, ist gewährleistet, dass diese Halbzeuggeometrien beim Walzplattieren stets sehr gut mit Weichlot "Umflossen" werden.

Dadurch, dass die Verbunddrähte (3) beim Walzplattiervorgang komplett umschlossen werden, ist das Lunker- und Porenverhalten beim Löten mit der erfindungsgemäßen Lötfolie (1) ebenso gering wie beim Löten mit monolithischen Lotfolien bzw. daraus hergestellten Lotformteilen.

Gleichzeitig führen die Spannungszustände die sich beim Walzplattieren zwischen dem Verbunddraht und dem Weichlot der Bänder (6) einstellen nicht dazu, dass das Umformvermögen der Bänder (6) überschritten wird.

Das Umformvermögen ist die Fähigkeit der Werkstoffe, ihre Gestalt unter dem Einfluss äußerer Kräfte - die im Werkstoff Spannungen erzeugen - plastisch in genügend großem Maße so zu verändern, dass der "Werkstoffzusammenhalt" nicht verloren geht, oder gar nicht erst hergestellt werden kann.

In Folge dieser erfindungsgemäßen Integration der Verbunddrähte im Weichlot, durch den erfindungsgemäßen Prozess des Walzplattierens, sind die Verbunddrähte in jedem Fall vollständig von Weichlot umschlossen. Erfindungsgemäß wird damit gewährleistet, dass dann wenn das Lot schmelzflüssig wird, sofort alle Bauteiloberflächen vollständig benetzt sind und so Benetzungsfehler vollständig ausgeschlossen werden können.

Mittels der erfindungsgemäßen Lösung ist es aber auch möglich die integrierten Verbunddrähte (3) in ihren Querschnittsgeometrien bewusst uneinheitlich auszuführen, um so sehr komplexe Geometrien eines Lötspaltes auch nachempfinden zu können.

Derartige sehr komplexe Geometrien eines Lötspaltes werden gegenwärtig beispielsweise in Verbindung mit dem Aufbau von Leistungshalbleitermodulen mit konkaven oder konvexen Ausbildungen der Lötspalte zwischen Substraten und Bodenplatten oder Kühlkörpern gefordert.

Mit den erfindungsgemäßen Lötfolien sind aber noch viel komplexere Geometrien in der Aufbau- und Verbindungstechnik realisierbar.

Dies wird zukünftig erforderlich werden, wenn die Module neben der elektrischen auch mechanische Funktion mit übernehmen sollen und nicht mehr in der üblichen "flachen" Konfiguration, sondern in komplexe 3D-Strukturen ausgeführt werden müssen.

Infolge der freien Wahl der geometrischen Ausführung der Querschnittsform der Weichlotmatrix und in Verbindung mit der freien Wahl der Form und der Anzahl der in dieser integrierten Verbunddrähte (3) sind den Layouts kaum Grenzen gesetzt.

Aus dieser erfindungsgemäßen Lötfolie (1) können dann durch Stanzen bzw. kombinierte Stanz-Umform-Prozesse kostengünstig die unterschiedlichsten Lotformteile (8), sog. Preforms, für die entsprechende Einsatzgeometrie hergestellt werden.

Mittels der erfindungsgemäßen Lötfolie (1) findet in einem herkömmlichen Bleifrei-Weichlötprozess mit im Stand der Technik für das Weichlöten üblichen Lötprofilen, in einem für das Weichlöten typischen Prozesstemperaturgebiet, d.h. bei vorzugsweise von 250° bis 300°C, aber mindestens 20-30K über den Liquidustemperaturen der verwendeten Weichlote und in Lötzeiten von unter 5 min, so auch bei Löttemperaturen bei bis zu ca. 280°C und in Lötzeiten von 5 min, dann beim Lötvorgang, infolge der metallurgischen Effekte, ein Umwandeln der Weichlotsäulen im, über und unter dem Mantelbereich der Verbunddrähte in höherschmelzende intermetallische Phasen um den Kern (4) des jeweiligen Verbunddrahtes (3) herum derart statt, dass komplette Brücken aus höherschmelzenden, intermetallischen Phasen bis hin zu den zu verbindenden Komponenten so ausgebildet werden, dass nach dem Löten, im Bereich von exakt definierten Querschnittsbereichen in der Verbindungszone (13) um die Kerne (4) der Verbunddrähte (3) herum nur höherschmelzende, feste Brücken angeordnet sind. Zwischen und neben diesen festen Brücken ist erfindungsgemäß nach dem Lötprozess in der Verbindungszone (13) weiterhin das Weichlotmaterial der ursprünglichen Weichlotmatrix angeordnet.

Die erfindungsgemäß im Lötprozess gebildeten höherschmelzenden, festen Brücken, d.h. die erfindungsgemäßen Bereiche von stoffschlüssigen Verbindungen zwischen den zu fügenden Bauteilen, weisen gegenüber dem diesen Brücken benachbarten Weichlotmaterial der Weichlotmatrix eine wesentlich höhere Festigkeit, aber zudem auch eine viel höhere Wiederaufschmelztemperatur auf.

So lösen die erfindungsgemäß aus intermetallischen Phasen ausgebildeten Brücken zwei grundlegende Probleme der Aufbau- und Verbindungstechnik die bei Stufenlötungen unter Einsatz von herkömmlichen Weichloten auftreten. Erstens wird durch die erfindungsgemäß ausgebildeten "höhertemperaturstabilen" Brücken zwischen den zu verbindenden Komponenten ein Verrutschen dieser Komponenten im Stufenlötprozess verhindert/vermieden, da die erfindungsgemäß gebildeten Brücken bei den Temperaturen in einem Weichlötprozess nicht mehr aufschmelzen können. Erfindungsgemäß bewirken diese Brücken aber auch, dass infolge ihrer höheren mechanischen Stabilität, bei Materialermüdung des Lotes, ein Rissfortschritt an diesen Brücken aufgehalten/unterbunden wird.

Da zwischen diesen sehr festen Brücken, die als Rissblock-Elemente fungieren, stets die duktile Weichlotmatrix angeordnet ist, vermag diese zudem erfindungsgemäß gleichzeitig die in der Verbindungszone auftretenden Spannungsüberhöhungen durch plastische Verformungen abzubauen. Zugleich ermöglichen diese sehr festen, schienenartigen Brücken, dass beim Löten ein "entgasungsoffener" Bereich neben / entlang der "Schienen" bzw. zwischen den benachbarten "Schienen" und den zu fügenden Oberflächen der benachbarten Bauteile verbleibt, der zum einen eine Entgasung der, an den zu fügenden Oberflächen der Fügepartner (d.h. zwischen den zu fügenden Oberflächen der Bauteile (z.B. keramisches Substrat (9), Bodenplatte (10) und den zu fügenden Oberflächen der Lötfolie (1)), beim Löten entstehenden Reaktionsprodukte, (d.h. das sich aus den beim Löten verwendeten reduzierenden Medien und den Oberflächenoxiden der Fügepartner als Reaktionsprodukt gebildete Gas (Wasserdampf oder ähnliches)), aus dem Bereich dieser Oberflächen der Fügepartner ermöglicht, und der es zum anderen aber auch möglich macht,-dass die zwischen den Oberflächen der Fügepartner vorhandenen Kavitäten, welche zumeist auf Grund einer von einer idealen Oberfläche abweichende Geometrie der zu fügenden Oberflächen, (infolge Rauheit, Welligkeit, Riefen, Kratzer usw.), "Atmosphären" bilden, die dann beim Löten entweichen können.

In der Gesamtheit wird mittels der erfindungsgemäßen Lösung eine völlig neuartige Lötverbindung erzeugt, welche neben dem Vorteil der exakten geometrischen Kontrolle der Lötstelle, bei Stufenlötungen die Prozessführung des Lötvorgangs wesentlich verbessert und zudem gleichzeitig einer Materialermüdung entgegenwirkt, wobei die Lebensdauer einer mit der erfindungsgemäßen Lotfolie (1) erzeugten Verbindungszone (13) gegenüber einer mit konventionellen Lötmaterialien der Aufbau- und Verbindungstechnik erzeugten Verbindungszone (13) deutlich besser (höher) ist.

Vorteilhafte Ausführungen, Einzelheiten und weitere Merkmale der Erfindung ergeben sich aus den Unteransprüchen sowie der nachfolgenden Beschreibung der erfindungsgemäßen Ausführungsbeispiele.

Nachfolgend soll nun die Erfindung in Verbindung mit sechs Darstellungen zur erfindungsgemäßen Lösung näher erläutert werden.
- Die Figur 1 zeigt: die erfindungsgemäße Anordnung zur Herstellung der erfindungsgemäßen Lötfolie 1.
- In der Figur 2 ist: in einer Schnittdarstellung ein aus der erfindungsgemäßen Lötfolie 1 bestehendes Lotformteil welches zwischen einem Substrat 9 und einer Bodenplatte 10 vor dem Lötprozess angeordnet ist, dargestellt.
- Die Figur 3 zeigt: die in der Figur 2 dargestellte Anordnung unmittelbar nach dem Weichlötprozess.
- Die Figur 4 zeigt: die in der Figur 3 dargestellte Anordnung nach einer längeren Einsatzzeit im Dauerbetrieb.
- In der Figur 5 ist: ein aus der erfindungsgemäßen Lötfolie 1 hergestelltes Lotformteil 8 mit zwei in einer Weichlotmatrix 2 integrierten Verbunddrähten 3, in einer räumlichen Darstellung.
- Die Figur 6 zeigt: ein aus der erfindungsgemäßen Lötfolie 1 hergestelltes Lotformteil 8 mit drei in einer Weichlotmatrix 2 integrierten Verbunddrähten 3, in einer räumlichen Darstellung.

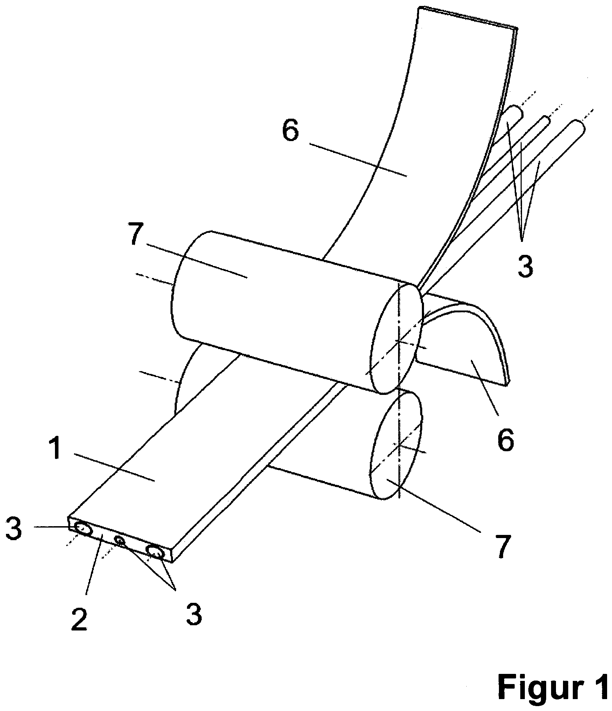

Die Figur 1 zeigt die erfindungsgemäße Anordnung zur Herstellung der erfindungsgemäßen bleifreien Lötfolie 1.

Ausgangsmaterial sind zunächst, wie in der Figur 1 dargestellt, zwei Folien bzw. Bänder 6 aus Weichlot, die in entfetteter und in schmutzfreier Oberflächenqualität vorliegen.

Diese Bänder 6 können zur verbesserten weiteren Verarbeitung vor dem Walzplattieren gebürstet werden, um äußere elastische Passivierungsschichten zu entfernen und zudem eine, der nachfolgend durchzuführenden Verbindung im Walzspalt, förderliche Oberflächenrauheit aufzuweisen.

Diese Folien oder Bänder 6 werden auf der Einlaufseite der Walzen 7 eines Walzgerüstes so angeordnet, dass zunächst das untere Band 6 aus · Lotwerkstoff durch den Walzspalt gefädelt wird.

Anschließend werden die Verbunddrähte 3, welche zweckmäßig auf Spulen aufgewickelt vorliegen, an den entsprechenden Haspelwellen mittig aufgebracht.

Der Verbunddraht 3 kann in runder oder aber auch ovaler Querschnittsform vorliegen.

Entsprechend der Anzahl der in der Lötfolie 1 zu integrierenden Verbunddrähte 3 werden diese auf der Einlaufseite des Walzgerüstes zwischen den Bändern angeordnet.

Bei einem einfachen Layout liegt die Zahl der zu integrierenden Verbunddrähte bei zwei.

Es können aber auch mehr Verbunddrähte 3, beispielsweise fünf und mehr Verbunddrähte 3, in einer erfindungsgemäßen Lötfolie 1 eingesetzt werden. Dabei kann die geometrische Form der Verbunddrähte 3, wie auch deren Dicke unterschiedlich gewählt werden.

Ein einfaches Beispiel sieht vor, zwei Verbunddrähte, runder Ausgangsform und gleichen Durchmessers zu verwenden.

In einem komplexeren Beispiel können auch drei oder mehr Verbunddrähte unterschiedlicher Form und vor allem unterschiedlichen Durchmessers verwendet werden.

Als Ausgangsmaterial für die Bänder 6, welche die Weichlotmatrix 2 nach dem Walzplattierprozess erzeugen, kommen alle gängigen, bleifreien, Zinn-Basis Legierungen, insbesondere: Sn; SnAg3,5; SnCu3; SnCu0,7; SnSb5; SnSb8; SnAg0,3Cu0,7; SnAg1Cu0,7; SnAg3,8Cu0,7; SnAg3,0Cu0,5; SnAg0,4Cu0,5 in Frage.

Aber auch Metalle und Legierungen auf Basis von Indium können verwendet werden, beispielsweise reines Indium oder InSn48.

Für den Kern 4 kommen vor allem Metalle und Legierungen aus reinem Kupfer und Kupferbasislegierungen, reinem Silber und Silberbasislegierungen sowie Nickel und Nickelbasislegierungen in Frage, dies vor allem in Kombination mit Zinnbasislegierungen für die einzusetzenden Weichlotfolien. Aber auch Gold und Goldbasislegierungen können in Kombination mit Indiumbasisloten verwendet werden, obgleich dies ein kostenintensives Beispiel für eine Materialkombination darstellt.

Für den Verbindungsvorgang beim Walzplattieren als auch für den Diffusionslötprozess ist es kennzeichnend, dass der Mantel 5 der Verbunddrähte 3 aus einem anderem Metall besteht, als der Kern 4.

Die im Vergleich zum Metall des Kernes 4 sehr spröden Randschichten des Mantels 5 (vornehmlich Zinnoxide) unterstützen den Verbindungsaufbau zu den Bändern 6 beim Walzplattierprozess, da diese spröden Schichten des Mantels 5 schon bei geringer Umformung aufreißen und dadurch Platz für das verbindungsfreundliche Material im Innern der Mantelschichten machen.

Dabei spielt es keine Rolle, ob der Mantel 5 des Verbunddrahtes 3, galvanisch oder aber durch Tauchen des Kernes 4 in Metallschmelzen erzeugt wurde.

Die Dicke der Mantelschicht kann von ca. 2% bis zu 20 % der Dicke des Gesamtdurchmessers des Verbunddrahtes 3 betragen.

Als "diffusionsgelötete Bereiche" um den Kern 4, des jeweils eingesetzten Verbunddrahtes 3, herum werden als höherschmelzende Phasen, je nach Wahl der Einsatz findenden Werkstoffe, die sich entsprechend dem Stand der Technik ausbildenden intermetallischen Phasen bzw. deren Kombinationen auftreten.

Um Wiederaufschmelztemperaturen der intermetallischen Phasen von ≥ 400°C zu erzielen sind stets Materialkombinationen, wie Zinnbasislot als Weichlotmatrix 2 mit Kernen 4 der Verbunddrähte 3 aus Kupfer-, Silber- oder Nickeldraht, oder Indiumbasislot als Weichlotmatrix 2 mit Kernen 4 der Verbunddrähte 3 aus Nickel- oder Golddraht anzustreben.

Das jeweilige Lötprofil, d.h. das Temperatur-Zeit-Regime beim Lötvorgang, entspricht dabei stets dem im Stand der Technik für die jeweilige Materialkombination üblichen Weichlötprofil mit dem für das bleifreie Weichlöten typischen Prozesstemperaturgebiet, d.h. bei beispielsweise bis zu ca. 280°C und in Lötzeiten von unter 5 min.

Die in der Figur 1 dargestellte Ausführungsform einer erfindungsgemäßen Lötfolie 1 zeigt mittig einen sehr dünnen Verbunddraht 3 dem beidseitig benachbart zwei dickere, hier gleich dicke Verbunddrähte 3, angeordnet sind. Diese Ausführungsform wird eingesetzt, um einen konkaven Lötspalt nachzubilden und eine möglichst hohe geometrische Exaktheit nach dem Löten zu gewährleisten.

Je nach Anforderung an die Geometrie des späteren Lötspaltes, können aber auch beliebig viele Verbunddrähte 3 mit unterschiedlichen Durchmessern verwendet werden.

Die Verbunddrähte 3 werden, gemäß Figur 1, in einem nächsten Prozessschritt durch ein Führungswerkzeug und dann durch den Walzspalt gefädelt, und dabei zum bereits durchgefädelten unteren Band 6 ausgerichtet.

Das Führungswerkzeug stellt beim nachfolgenden Walzplattieren sicher, dass die Verbunddrähte 3 nur an den gewünschten Stellen einplattiert werden und definiert somit auch den Abstand der Verbunddrähte 3 zueinander sowie den Abstand der Verbunddrähte 3 zu den Längskanten der Lotfolie 1.

Nachdem die Verbunddrähte 3 auf diese Weise zum unteren Band 6 ausgerichtet wurden, werden Sie auf der Auslaufseite der Walzen 7 mechanisch fixiert.

Als nächstes wird das obere Band 6, welches über den Verbunddrähten in den Walzspalt zwischen den Walzen 7 einläuft, durch die Walze gefädelt und anschließend Kante an Kante zum unteren Band 6 ausgerichtet.

Es ist vorteilhaft gleich breite Folien oder Bänder 6 aus Weichlot zu verwenden. Für einen kontinuierlichen Prozess ist es ebenso zweckmäßig, das eingesetzte Material in gewickelter Form, sog. Coils, zu verwenden.

Nachdem die Bänder 6 und die Verbunddrähte 3 in gewünschter Anordnung durch den Walzspalt gefädelt vorliegen, wird der Walzspalt geschlossen. Durch die Einstellung des minimalen Abstandes der Walzen zueinander, wird die Dicke des resultierenden Werkstoffverbundbandes eingestellt.

Wird nun mit dem Walzprozess begonnen, umfließt, infolge einer Plastifizierung der Metalle im Walzspalt, der weichere Werkstoff der Lote die abgerundeten Bereiche der festeren Verbunddrähte 3, formt diese ein und verbindet sich untereinander wieder, sodass ein stoffschlüssiger Werkstoffverbund, die erfindungsgemäße Lötfolie 1, gefügt wird. Die beim Walzplattieren hierfür nötigen "prozentualen Höhenreduktionen der Ausgangsbänder" (ermittelt aus dem Quotienten, aus der Differenz zwischen der summarischen Ausgangshöhe der Bänder 6 (ermittelt ohne Hinzurechnung der Höhe der Verbunddrähte 3) und (d.h. abzüglich) der End-Höhe H der Verbundfolie 1 (mit eingebetteten Verbunddrähten 3), bezogen auf die summarische Ausgangshöhe der Bänder 6, in Prozent) liegen, je nach Wahl der verwendeten Werkstoffe für die Lotfolien/Lotbänder und die jeweils eingesetzten, einzeln und parallel zueinander und parallel zu den Bandkanten, längs zur Walzrichtung ausgerichteten Verbunddrähte, im Bereich von größer als 30 % bis 95 %, (der summarischen Höhe der Ausgangsbänder).

Wird beispielsweise als Ausgangsmaterial des Verbunddrahtes 3 ein Runddraht eingesetzt, wird dieser bei der ablaufenden Umformung im Walzspalt an eine ovale Geometrie angenähert.

Wie bereits erwähnt, können auch bereits ovale Verbunddrähte 3 als Ausgangsmaterialform eingesetzt werden.

Wichtig bei der Erzeugung der Plattierung ist die abgerundete Form der Verbunddrahtoberfläche.

Im Rahmen der erfindungsgemäßen Lösung finden Verbunddrahtquerschnittsgeometrien mit ausgeprägten Kantenformen keinen Einsatz.

Nur bei abgerundeten Formen der Manteloberflächen der Verbunddrähte 3 kann der weichere Werkstoff der Weichlotmatrix 2 den Verbunddraht 3 beim Umformvorgang stoffschlüssig umfließen, ohne dabei zu großen Widerständen im Stofffluss zu begegnen.

Das Lotmaterial der Weichlotmatrix 2 ist dabei, an den Stellen, an denen der Verbunddraht 3 umschlossen wird, sehr großen lokalen Umformgraden ausgesetzt.

Die runde Form der Oberfläche der Verbunddrähte 3 verbessert ein Umschließen der Verbunddrähte, ohne dass der Stoffzusammenhalt des Lotes (Bruch/Riss) verloren geht und ermöglicht auf diese Weise erst, das auch sehr dicke Verbunddrähte 3, wie beispielsweise Verbunddrähte 3 mit einem Durchmesser der das 2,5-fache der Dicke der (Ausgangs-) Bänder 6 aus Lotwerkstoff beträgt, stoffschlüssig integriert werden können, ohne das mit einer inneren oder äußeren Schädigung des Verbundes zu rechnen ist.

Nur so können auch die nötigen, sehr dünnen Schichten an Weichlot von 5 µm bis maximal 15 µm, die nach dem Plattiervorgang über und unter den Bereichen mindestens eines der integrierten Drahtkerne 4 liegen und für ein Diffusionslöten notwendig sind, erzielt werden.

Im Rahmen des erfindungsgemäßen Prozessablaufs, stellt es kein Problem dar, auch sehr unterschiedlich dicke Verbunddrähte 3, oder Verbunddrähte 3, die lediglich nur noch ein Drittel des ursprünglichen Durchmessers des dicksten Verbunddrahtes 3 betragen, oder in Ausnahmefällen noch kleiner sind, in der Lotmatrix zu integrieren.

Auch können unterschiedliche Legierungen für die Kerne 4 der integrierten Verbunddrähte 3, verwendet werden.

Beispielsweise unterschiedlich feste Kupferlegierungen oder reines Kupfer mit unterschiedlichem Kaltverfestigungsgrad.

Der Hintergrund für die Verwendung unterschiedlich fester Legierungen ist, dass die unterschiedlichen Verbunddrähte 3 beim Walzplattieren im Vergleich zum Lot auch unterschiedlich stark verformt werden.

Die Verbunddrähte 3 mit den weicheren Drahtkernlegierungen werden beim Walzplattieren flacher und immer ovaler und nehmen im Vergleich zu festeren Metallen und Legierungen weniger Höhe im Gesamtverbund ein.

Durch Wahl unterschiedlich fester Legierungen können also auch verschiedene geometrische Layouts der erfindungsgemäßen Lötfolie 1 erzeugt werden.

Entsprechend der verwendeten Metallen für die Bänder 6, die Weichlotmatrix 2 und die Verbunddrähte 3 kann es notwendig sein, die Ausgangsmaterialien vor oder bei Walzspalteintritt zu erwärmen, um eine verbesserte Umformbarkeit zu erzielen.

Auch kann die Lötfolie 1 in Nachfolgewalzschritten zu einer noch dünneren Lötfolie 1 ausgewalzt werden.

Die erfindungsgemäße Lösung sieht ebenfalls vor, aus den so erzeugten erfindungsgemäßen Lötfolien 1 Lotformteile herzustellen, um eine sehr exakte Vorportionierung der Lötfolie 1 für die erwünschten Lötstellen vorzunehmen. Dies kann beispielsweise durch Verfahren wie Stanzen, Laserschneiden, Mikroätzen oder konventionelle Scherschneideverfahren erfolgen.

Außerdem können auch kombinierte Verfahren zum Herstellen von komplexgeometrischen Lotformteilen, die Trennen und gleichzeitiges Umformen (Tiefziehen, Prägen) beinhalten, angewandt werden.

Da bekannt ist, dass stark verkippte Lotstellen mechanisch eher versagen und zum Bilden unerwünschter Hotspots führen als homogen dicke Schichten, fordern viele Anwendungsfälle lediglich zwei gleich hohe Verbunddrähte 3, die möglichst dick in der Lötfolie 1 vorliegen und dabei in einem exakten Abstand zueinander ausgeführt sind, und dass beispielsweise in einem Lotformteil, die Verbunddrähte, möglichst kantennah integriert vorliegen.

Beim Lötvorgang wird dann so ein Verkippen der Komponenten unterbunden und eine möglichst homogene Lötschicht gewährleistet.

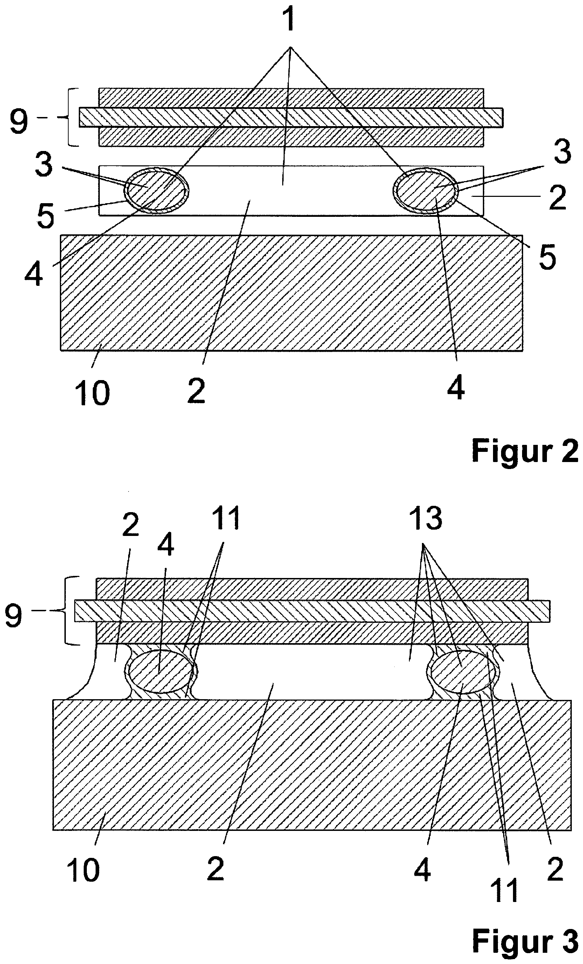

Die Figur 2 zeigt eine Schnittdarstellung vor dem Lötprozess, in der ein aus der erfindungsgemäßen bleifreien Lötfolie 1 bestehendes Lotformteil 8 zwischen ein keramisches Substrat 9, das im hier vorgestellten Ausführungsbeispiel eingesetzt und auch als DCB, DBC oder AMB bekannt ist, und einer Bodenplatte 10 angeordnet ist.

Dieses aus der erfindungsgemäßen Lötfolie 1 bestehende, und aus der Lötfolie 1 ausgestanzte Lotformteil 8 ist erfindungsgemäß so aufgebaut, dass in der Weichlotmatrix 2, welche bei diesem Ausführungsbeispiel aus einem bleifreien Zinnbasislot besteht, zwei Verbunddrähte 3 einplattiert, d.h. in der Weichlotmatrix kompakt integriert sind, und die erfindungsgemäß einen Kern 4 aufweisen der aus einem gegenüber der Weichlotmatrix 2 höherschmelzenden und zugleich festeren Metall oder einer Metalllegierung, hier aus Kupfer, bestehen, um den herum ein Mantel 5 aus einem anderen Metall oder einer anderen Metalllegierung, hier aus einer Zinnbasislegierung, angeordnet ist. Erfindungsgemäß wird diese Anordnung, nachdem der "Stapel" erzeugt wurde, in einem Weichlötprozess mit einem für Weichlötprozesse typischen Lötprofil in einem für das Weichlöten typischen Prozesstemperaturgebiet, (d.h. bei bis zu ca. 280°C und in Lötzeiten von unter 5 min erhitzt) und dabei die Weichlotmatrix in den schmelzflüssigen Zustand überführt.

Dies kann, wie beispielsweise im Stand der Technik üblich, in Vakuum-Öfen, zumeist unter Einwirkung reduzierender Gase erfolgen.

Das flüssige Lot breitet sich dabei auf den mit ihm in Kontakt-stehenden Oberflächen aus.

Erfindungsgemäß bilden sich dabei, wie in der Figur 3 dargestellt, aufgrund von Diffusionsvorgängen zwischen Metallatomen aus dem Verbunddrahtbereich und dem flüssigen Lot um die Verbunddrähte bis zu den benachbarten Bauteiloberflächen (d.h. bis zum Substrat 9 und der Bodenplatte 10) reichende, zwischen dem Lot und den zu benetzenden Materialien angeordnete Diffusionszonen aus, d.h. Bereiche mit neuer chemischer Zusammensetzung, sogenannte intermetallische Phasen 11.

Mit monolithischen Weichloten gelötete Verbindungszonen weisen über den Querschnitt betrachtet nach dem Weichlöten, eine aus den Ausgangsbestandteilen bestehende Verbindungszone auf, die die gleiche chemische Zusammensetzung wie vor dem Löten besitzt.

Wird hingegen mit der erfindungsgemäßen Lötfolie 1 gelötet, so bilden sich, aufgrund der erfindungsgemäß beim Weichlötprozess mit Weichlötprofilen ablaufenden Diffusionsvorgänge zwischen dem Verbunddraht 3 und der flüssigen Weichlotschmelze, um den Kern 4 herum Bereiche mit chemisch veränderter Zusammensetzung.

Im vorliegenden Ausführungsbeispiel wird als Lotmatrix das Lot SnCu3 eingesetzt.

Die Verbunddrähte 3 bestehen im Kern 4 aus unlegierten, reinem Kupfer mit einem Mantel 5 aus einer Zinnbasislegierung.

Beim Weichlöten bilden sich erfindungsgemäß um diese Kerne 4 intermetallischen Phasen aus Cu3Sn und Cu6Sn5.

Da die Abstände zwischen den randseitig integrierten ovalen Kernen der Verbunddrähte und den Oberflächen der zu fügenden Bereiche im vorliegenden Ausführungsbeispiel an den dünnsten Stellen nur 5 µm bis maximal 15 µm betragen (12,5 µm im Ausführungsbeispiel), wachsen diese Bereiche sehr schnell mit intermetallischen Phasen zu.

Dabei bilden sich um den Kern 4 herum und zwischen dem Kern 4 und dem Substrat 9, wie auch zwischen dem Kern 4 und der Bodenplatte 10, die in der Figur 3 dargestellten Brücken aus intermetallischen Phasen 11 aus.

Diese intermetallischen Phasen 11 sind durch eine höhere Festigkeit und Härte wie auch einem gegenüber der Einsatz findenden Weichlotmatrix 2 höheren Schmelzpunkt (Schmelzpunkt der intermetallischen Phasen 11 ist abhängig von den jeweils Einsatz findenden Werkstoffen und liegt zumeist ≥ 415°C) charakterisiert.

Die Verbindungszone zwischen dem Substrat 9 und der Bodenplatte 10 besteht nach dem Löten mit der erfindungsgemäßen Lötfolie 1, im Vergleich zum Löten mit monolithischem Weichlotmaterial nicht nur aus duktilem Weichlot, sondern einerseits aus Brücken bestehend aus sehr festen, temperaturstabilen intermetallischen Phasen 11 und anderseits aus an diese Brücken angrenzendem duktilem Weichlot der Weichlotmatrix 2.

Diese Eigenschaften in einem Werkstoff vereint, werden in der Werkstoffkunde als "zäh" bezeichnet.

Nach der Fertigstellung der Baugruppe wird diese dann wie allgemein üblich eingesetzt, dabei wird die in den Halbleiterbauelementen erzeugte Verlustleistung in Form von Wärme über das Substrat 9 und die jeweilige Weichlotverbindungszone des Standes der Technik in die Bodenplatte 10 abgeleitet.

Die unterschiedlichen Materialien der einzelnen Bauteile dehnen sich dabei entsprechend ihres jeweiligen Wärmeausdehnungskoeffizienten unterschiedlich stark aus.

Setzt zwischenzeitlich, wie allgemein üblich, der Betrieb kurz- oder auch langzeitiger aus, dann wird vom Halbleiterbauelement keine Verlustleistung in Form von Wärme mehr abgegeben, die Materialien kühlen dann ab und ziehen sich dabei zusammen.

In Folge dieser ständigen thermischen Lastwechsel werden aufgrund der unterschiedlichen Ausdehnungen Spannungen in den Materialien erzeugt. Diese konzentrieren sich insbesondere an den Randbereichen der Verbindungszone.

Diese Randbereiche der Verbindungszone werden aufgrund der Vielzahl der thermischen Lastwechsel über die Einsatzzeit hoch beansprucht.

Man spricht in diesem Zusammenhang auch von der Degradation des Lotes. Bei herkömmlichen monolithischen Weichlotverbindungen sind im Anfangsstadium lediglich die Kantenbereiche der Lötstelle/Verbindungszone von Rissen betroffen.

Im Anfangsstadium wird die Funktionsfähigkeit des Gesamtbauteils noch nicht eingeschränkt.

Im weiteren Dauerbetrieb wachsen bei herkömmlichen Weichlotverbindungen dann diese Risse im Weichlot der Verbindungszone bis unter die Bereiche, über denen die Leistungshalbleiterbauelemente sitzen.

Die Wärme kann dann nur noch sehr schlecht abgeführt werden.

Das Halbleiterbauelement wird dadurch zu heiß und es kommt dann zu einem Versagen der gesamten Baugruppe.

Mittels der mit der erfindungsgemäßen Lösung im Weichlötprozess gebildeten neuartigen Lötverbindung kann nun eine wesentlich längere Lebensdauer der gesamten Baugruppe, wie beispielsweise des gesamten Leistungshalbleitermoduls, gegenüber dem Stand der Technik gewährleistet werden.

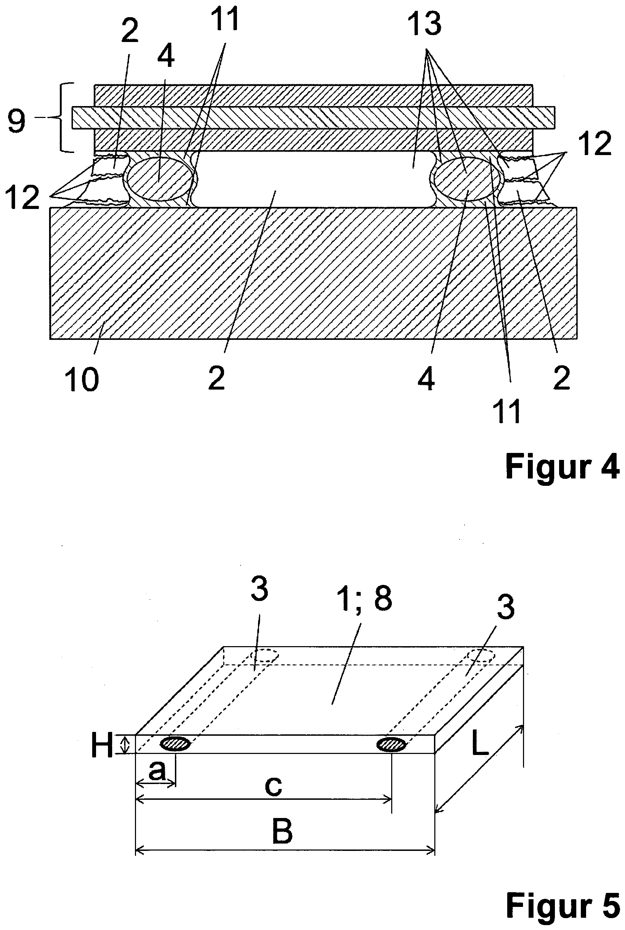

Die Figur 4 zeigt die in Figur 3 dargestellte erfindungsgemäße Lotverbindung (in Verbindung mit einem Leistungshalbleitermodul) nach längerem Dauerbetrieb.

Aus dieser Darstellung wird deutlich, wie mittels der erfindungsgemäßen Lösung das weitere Wachstum der Risse 12 verhindert wird.

Die duktile Weichlotmatrix 2 gewährleistet in der Mitte der Verbindungszone 13 in Verbindung mit den stabilen Brücken aus intermetallischen Phasen 11 einen optimalen Abbau der Wärmespannungen.

An den Rändern der Verbindungszone 13 kann es nach einer Vielzahl von thermischen Lastwechselzyklen, dennoch zur Ausbildung von Rissen 12 in Folge von Ermüdungserscheinungen des Weichlotmaterials kommen.

In diesem Zusammenhang bewirken nun, wie in der Figur 4 dargestellt, die Brücken aus den sehr festen, intermetallischen Phasen 9, welche um die Kupferdrähte 3 erfindungsgemäß ausgebildet wurden, dass diese Risse 12 an einer weiteren Ausbreitung gehindert werden.

Daher ist es erforderlich und zwangsläufig vorteilhaft die Verbunddrähte 3 so nah wie möglich, bzw. so nah wie nötig an den Kanten/Rändern der Lotformteile 8 zu integrieren, um dadurch unterhalb der Bereiche des Sitzes der Halbleiterbauelemente einen Riss (-fortschritt) zu verhindern.

Infolge der in der Lötfolie 1 einplattierten Verbunddrähte 3 mit integrierten Kernen 4 aus Kupfer, Silber oder Gold wird gegenüber dem umgebenden Weichlot zudem gleichzeitig eine weitere, deutliche Verbesserung der Wärmeleitfähigkeit der Verbindungszone 13 gewährleistet, wodurch die Lebensdauer des Leistungshalbleitermoduls nochmals deutlich erhöht wird. Infolge der erfindungsgemäß deutlich verbesserten Wärmeableitung wird es möglich, dass die Betriebstemperaturen der gesamten Baugruppe weiter sinken und auch dadurch das Auftreten von thermomechanischen Spannungen nochmals deutlich reduziert wird.

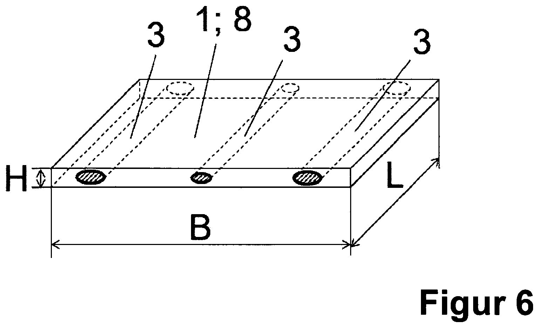

In den Figuren 5 und 6 sind, in räumlichen Ansichten, zwei unterschiedliche, aus unterschiedlichen erfindungsgemäßen Lötfolien 1 hergestellte, Lotformteile 8 dargestellt.

Die Figur 5 zeigt, in einer räumlichen Darstellung, ein aus der erfindungsgemäßen Lötfolie 1 hergestelltes Lotformteil 8 mit zwei in einer Weichlotmatrix 2 integrierten/einplattierten Verbunddrähten 3 zur Gewährleistung einer homogenen Lotschichtdicke nach dem Lötprozess.

Um beispielsweise ein Halbleiterbauelement mit Rückseitenmetallisierung auf ein Cu-Keramik-Substrat zu löten, werden die in Figur 5 dargestellten, aus der erfindungsgemäßen Lötfolie hergestellten Lotformteile 8 mit den Abmessungen von beispielsweise B = 15 mm x L = 15 mm eingesetzt.

Mit dem vorliegenden Ausführungsbeispiel soll eine Verbindungszone 13 mit einer Höhe H = 100 µm gewährleistet werden.

Da das Halbleitermaterial keine nennenswerte Durchbiegung aufweist, und das Substrat über die Ausdehnung dieses Bereichs ebenfalls keine nennenswerte Abweichung von einer ebenen Oberflächengestalt bietet, reicht es, die Lötstelle mit zwei randseitig sitzenden, gleich hohen Verbunddrähten 3 zu stabilisieren. Die hierzu benötigten Lotformteile 8 werden aus einer erfindungsgemäßen Lötfolie 1 gefertigt, die wie folgt hergestellt wird.

Als Ausgangsmaterial dienen zwei Weichlot - Bänder 6 aus SnCu3 der Dicke 0,340 mm und Breite 70,0 mm in Verbindung mit sechs separat geführten Verbunddrähten 3 mit einem Kern 4 aus Kupfer mit einem Mantel 5 aus Zinn. Die Bänder 6 und Verbunddrähte 3 werden über entsprechende Führungswerkzeuge, wie bereits erläutert, dem Walzspalt zugeführt, und dabei zueinander so ausgerichtet, dass die Weichlot- Bänder 6 wieder deckend übereinander in den Walzspalt einlaufen und die Verbunddrähte 3 exakt beabstandet dazwischen angeordnet sind.

Die einzeln laufenden Verbunddrähte 3 werden dabei in einem Abstand von 10,0 mm zueinander ausgerichtet.

Der Abstand zu den Bandkanten wird ebenfalls mit 10,0 mm geführt.

Die Verbunddrähte 3 bestehen im Kern 4 aus ziehharten Kupfer mit einem Durchmessers von 500 µm und besitzen einen Mantel 5 von 25 µm dicken Zinn.

Der Verbund wird an eine Dicke von 220 µm plattiert und mit zwei nachfolgenden Walzstichen auf die Enddicke von 100 µm reduziert.

Aus dieser erfindungsgemäßen Lötfolie 1 können nun über die Breite fortlaufend drei Lotformteile pro Stanz-Hub der Abmessung 15,0 mm x 15,0 mm ausgestanzt werden.

Das Stanzwerkzeug und der Sitz der Stempel werden dabei so ausgeführt, dass ein Abstand der Stempel zu den Bandkanten von 7,5 mm besteht und die Stempel untereinander einen Abstand von 5 mm besitzen.

Damit werden Preforms/Lotformteile 8 aus der Lötfolie 1 ausgestanzt, bei denen die zwei integrierten Verbunddrähte einen Abstand von 2,5 mm zu ihren Außenkanten besitzen.

Der geometrische Aufbau eines dieser Lotformteile ist räumlich in der Figur 5 dargestellt.

Dabei ist die Höhe des Lotformteils 8, H = 0,100 mm; die Breite des Lotformteils 8, B = 15,0 mm; die Länge des Lotformteils 8, L = 15,0 mm.

Die zu einer ovalen Geometrie verformten Verbunddrähte 3 haben folgende Ausdehnung, der größere Durchmesser beträgt ca. 430 µm, der kleinere Durchmesser, welcher nachfolgend maßgeblich für die Kontrolle einer homogenen Lotschichtdicke verantwortlich ist, besitzt eine Ausdehnung von ca. 84 µm.

Die Weichlotsäulen/Weichlotdicken über den in der erfindungsgemäßen Lötfolie 1 (der Höhe H = 100 µm) einplattierten Verbunddrähten 3, beträgt an der dünnsten Stelle ca. 8 µm.

Diese ca. 8 µm starken Lotschichten werden erfindungsgemäß beim Löten mit den für das Weichlöten typischen Weichlötprofilen, d.h. mit den in einem für das Weichlöten typischen Prozesstemperaturgebiet, bei bis zu ca. 280°C und in Lötzeiten von unter 5 min komplett in die höherschmelzenden intermetallischen Phasen, hier Cu6Sn5 und Cu3Sn umgewandelt. Erfindungsgemäß werden dabei entlang der beiden während des Lötprozessen integrierten Verbunddrähte 3 sowohl zur Substratoberfläche hin, als auch zur Rückseitenmetallisierung des Halbleiters hin, komplette Brücken aus höherschmelzenden intermetallischen Phasen geschaffen, die unter anderem in Verbindung mit der Kernen der Drähte dafür sorgen, dass eine Verkippung des aufgelöteten Halbleiterbauelements im Vergleich zum Substrat vermieden, und gleichzeitig eine hochexakte Fixierung des Halbleiterbauelements gegenüber dem Substrat, sowohl für den Transport, wie auch für einen nachfolgenden Lötprozess im nächsten Ofenraum, gewährleistet ist.

In diesem nachfolgenden Lötprozess, wird dann beispielsweise das mit dem Halbleiterbauelement verbundene Substrat 9, noch mit einem Kühlkörper verlötet.

Die erfindungsgemäße Lösung bewirkt dabei, dass weder beim Transport in eine nächste Ofenkammer noch beim nächsten Lötprozess das zuvor mit dem Substrat 9 bereits gelötete Halbleitermaterial "verrutschen" kann.

Mit der hier vorgestellten Erfindung wird eine Lösung vorgestellt, bei der nur die Bereiche um die einplattierten Verbunddrähte 3 in höherschmelzende, feste Intermetallische Phasen 11 umgewandelt werden.

Der Rest der Verbindungszone 13 besteht aus Weichlot der ursprünglichen Zusammensetzung.

Damit liegen genügend Bereiche vor, welche die beim Fügen und unter Einsatzbedingungen auftretenden thermomechanischen Spannungen durch duktiles Materialverhalten kompensieren, was in Verbindung mit einer Verbindungszone 13 die zum überwiegenden Teil aus spröden intermetallischen Phasen 11 besteht nicht möglich ist, und bereits beim Lötvorgang zum Versagen der Halbleiterbauelemente führen kann.

Die Figur 6 zeigt nun ein Lotformteil 8 mit drei in einer Weichlotmatrix 2 integrierten Verbunddrähten 3.

Mittels diesem Lotformteil 8 soll eine konkave Lötstelle während einer "Substrat 9 - zu - Bodenplatten 10 Lötung" stabilisiert werden, die sich aufgrund der Verwendung einer vorgebogenen Bodenplatte 10 und einem zugeordneten bi-konvexen Substrat 9 ergibt.

Dabei sollen die zwei dicken, kantennah-integrierten Verbunddrähte 3 für eine möglichst geringe Verkippung des Substrates 9 und damit für eine möglichst homogene Lotschichtdicke in einer Verbindungszone 13 von ca. 180µm sorgen.

Ein dritter, zentrisch sitzender Verbunddraht 3 mit kleinerer Dicke soll die konkave Lötstelle stabilisieren.

Für die Herstellung der erfindungsgemäßen Lötfolie 1 als Ausgangsmaterial zur Herstellung der Lotformteile 8 werden zwei gebürstete Bänder 6 aus SnAg3,5 mit einer Dicke von 0,470 mm und einer Breite von 70 mm, sowie drei Verbunddrähte 3 mit Kupfer als Material für den Kern 4 mit einer galvanischen Verzinnung des Kerns 4 als Mantel 5, im ziehharten Zustand eingesetzt.

Die beiden randseitig angeordneten Verbunddrähte 3 sind rund, besitzen vor dem Walzplattieren einen Außendurchmesser von 0,8 mm und haben eine Schichtdicke des Mantels 5 aus Zinn von ca. 25 µm.

Der Dritte, der mittlere Verbunddraht 3 besitzt einen Durchmesser von 0,55 mm und hat ebenfalls einen Mantel 5 aus ca. 25 µm dickem Zinn.

Das untere gebürstete Band 6 wird von einem Abwickler durch den geöffnet Walzspalt, ein Führungswerkzeug passierend, gefädelt und einer Aufwickeleinheit zugeführt.

Der mittlere Verbunddraht 3 wird von einer Spule durch ein Führungswerkzeug gefädelt und genau mittig zum unteren gebürsteten Band 6 ausgerichtet.

Der mittige Verbunddraht 3 wird auf der Auslaufseite fixiert.

Danach wird ein randseitiger Verbunddraht 3 mit dem Außendurchmesser von 0,800 mm von einer Spule abgewickelt und durch ein Führungswerkzeug gefädelt, und rechts des mittig laufenden Verbunddrahtes angeordnet.

Der Abstand zu dem mittig geführten Verbunddraht soll in diesem Ausführungsbeispiel 20 mm betragen.

Dadurch entsteht ein Abstand von 15 mm zum rechten Rand des unter dem Verbunddraht liegenden SnAg3,5-Bandes 6.

Der dritte Verbunddraht 3, welcher linksseitig der Mitte des Bandes 6 laufen soll und der ebenfalls einen Durchmesser von 0,800 mm hat, wird von einer Spule gewickelt durch ein Führungswerkzeug gefädelt und in einem Abstand von ebenfalls 20 mm zum mittig laufenden Verbunddraht angeordnet.

Die links- und rechtseitig der Mitte laufenden Verbunddrähte 3 werden auslaufseitig der Walze ebenfalls fixiert.

Das obere SnAg3,5-Band 6 wird als letztes, von der seitlichen Anordnung her deckungsgleich mit dem unteren SnAg3,5-Band 6, durch den Walzspalt, dabei ebenfalls ein Führungswerkzeug passierend, gefädelt.

Der Walzspalt zwischen den Walzen 7 wird dann so eingestellt, dass eine erfindungsgemäße Lötfolie 1 mit einer Dicke von 0,350 mm entsteht.

Dabei werden die runden Verbunddrahtquerschnitte zwischen den SnAg3,5 Folien eingeformt und vom Weichlot umschlossen.

Mit zwei aufeinander folgenden Walzstichen wird die Dicke der erfindungsgemäßen Lötfolie 1 dann weiter auf 180 µm reduziert.

Die so hergestellte, erfindungsgemäße Lötfolie 1 hat einen Rechteckquerschnitt mit einer Höhe H = 0,18 mm und einer Breite von ca. 70 mm, mit einer Weichlotmatrix aus SnAg3,5.

Die zum Oval gestauchten/verformten Verbunddrähte 3 sind zentrisch/symmetrisch zum Flächenschwerpunkt des Rechteckquerschnittes in der Weichlotmatrix eingebettet.

Der kleinere Durchmesser des mittleren Drahtes beträgt etwa 120 µm und dessen größter Durchmesser beträgt ca. 395 µm.

Die beiden randseitig angeordneten Verbunddrähte 3 werden ebenfalls zu ovalen Formaten umgeformt mit ca. 155 µm für den kleineren Durchmesser des Ovals und ca. 620 µm für den größeren Durchmesser des Ovals.

Die Flächenschwerpunkte der Ovale befinden sich dabei stets mittig, das heißt auf halber Höhe der Gesamtdicke/Gesamthöhe, in der erfindungsgemäßen Lötfolie 1.

Durch die Führungswerkzeuge wird gleichzeitig gewährleistet, dass die Abstände der Flächenschwerpunkte der Verbunddrahtovale äquidistant über den gesamten Walzplattiervorgang gehalten werden.

Nachfolgend werden aus dieser erfindungsgemäßen Lötfolie 1 dann Stanzteile, sog. "Preforms" mit folgenden Abmessungen (siehe Figur 5): Höhe H = 180 µm; Breite B = 46,5; Länge 38,0 mm ausgestanzt.

Die Stanzteile können aus dieser, wie oben erläutert hergestellten, erfindungsgemäßen Lötfolie 1 von einer (sinnvollen) Mindest-Breite B von 43,0 mm bis zur maximalen Breite B des Bandes von 70,0 mm hergestellt werden. Die Länge L der Lotformteile 8 könnte sinnvoller Weise theoretisch von 5,0 mm bis über 100 mm betragen.

Im Weichlötprozess wird mit dieser erfindungsgemäßen Lötfolie 1 mit einer Peaktemperatur im Lötprofil von 250°C-260°C gearbeitet.

Hierbei wird das SnAg3,5 Lot schmelzflüssig.

Gleiches gilt für den Zinnmantel der Kupferdrähte.

Durch die erfindungsgemäße Umwandlung eines Teils des Weichlotes im Bereich der Verbunddrähte 3 in die intermetallischen Phasen Cu6Sn5 und Cu3Sn verringert sich der Anteil des flüssigen Weichlotes, welches über und unter den randseitigen Verbunddrähten liegt, sodass der Wert, um den das Substrat absolut verkippen kann ≤ 10 µm ist.

Der mittlere Verbunddraht, da dieser etwas dünner in seiner Ausführung dimensioniert ist, lässt eine Verkürzung des Abstandes zwischen der Unterkante des Substrates 9 und der Oberkante der Bodenplatte zu, sodass eine konkave Form für den Lötspalt möglich gemacht wird. Gleichzeitig verhindert er ein zu weites Einsinken, d.h. Annähern, der Substratunterseite zur Bodenplattenoberseite in der Mitte.

Damit wird das Substrat 9 von drei Verbunddrähten 3 abgestützt.

Der mittlere Verbunddraht 3 verhindert auch, dass die randseitigen Verbunddrähte 3 beim Löten herausgequetscht werden können, falls der Gesamtaufbau beim Lötprozess einem starken Anpressdruck ausgesetzt werden würde.

Mit dem erfindungsgemäßen Material werden auch folgende Vorteile miteinander vereint, zum einen, dass das Risswachstum bei Materialermüdung an den Stellen um die Drähte herum geblockt wird und damit die Lebensdauer der Lötstellen erhöht wird, zum anderen, dass durch das Vorhandensein von großen Bereichen an duktilem Weichlot ein Fügen von Materialien erlaubt wird, die aufgrund unterschiedlichen thermischen Ausdehnungsverhaltens große thermomechanischen Spannungen hervorrufen.

Mittels der erfindungsgemäßen Lehre wird somit eine neuartige Lötfolie 1 bereitgestellt, die das Einstellen einer definierten und reproduzierbaren Verbindungszonengeometrie, ob einfacher oder aber auch komplexer Gestalt nach dem Lötprozess ermöglicht, und die auch für Stufenlötprozesse geeignet ist, um mit einem für das Weichlöten typischen Lötprofil, d.h. in einem für das Weichlöten typischen Prozesstemperaturgebiet, d.h. bei vorzugsweise von 250°C bis 300°C und in Lötzeiten von unter 5 min, wie auch ohne eine anschließende Wärmebehandlung und ohne die Ausübung einer Presskraft während des Lötens, bei gleichzeitiger Vermeidung der Ausbildung von Poren und oder Lunkern in der Verbindungszone, das Verrutschen von gelöteten Komponenten auch im Rahmen von sogenannten Stufenlötprozessen, bei denen die Gefahr eines Wiederaufschmelzens zuvor gelöteter Bereiche besteht, dadurch verhindert, dass im Lötprozess mit hoher geometrischer Exaktheit mit den metallischen / metallisierten Oberflächenschichten der zu verlötendenden Bauteile festverbundene, in Ihren Abmessungen und ihren Beabstandungen exakt definierte, komplette Brücken aus höherschmelzenden, intermetallischen Phasen ausbildet werden, die eine Wiederaufschmelztemperatur von höher als 400°C aufweisen, und die in den Abmessungen eine hochgenaue, geometrisch exakte Verbindungszone gewährleisten, welche zudem aufgrund der mechanischen Festigkeit dieser temperaturstabilen Brücken gleichzeitig einen Rissfortschritt in der Verbindungszone bei Materialermüdung des Lotes unmittelbar an den Brücken unterbindet / aufhält, wobei das die Brücken umgebenden Weichlot, die Weichlotmatrix, zugleich die durch das Löten eingebrachte, aber auch die während des Bauteileinsatzes entstehenden thermomechanischen Spannungen aufnimmt, und dadurch einer Materialermüdung entgegenwirken, wodurch im Wirkgesamtzusammenhang die hier vorgestellte Lösung die Lebensdauer der Verbindungszone, gegenüber einer mit konventionellen Lötmaterialien nach dem Stand der Technik der Aufbau- und Verbindungstechnik hergestellten Verbindungszone, deutlich erhöht, und dabei gleichzeitig die thermische Leitfähigkeit der gesamten Verbindungszone infolge der eingebetteten Cu Drähte (oder Ag, oder Ni usw.) deutlich verbessert.

### Bezugszeichenzusammenstellung

- 1: Lötfolie
- 2: Weichlotmatrix
- 3: Verbunddraht
- 4: Kern
- 5: Mantel
- 6: Band (Folie)
- 7: Walze
- 8: Lotformteil
- 9: keramisches Substrat
- 10: Bodenplatte
- 11: Intermetallische Phase
- 12: Riss
- 13: Verbindungszone

- H: Höhe
- B: Breite
- L: Länge
- a: Randabstand
- c: Abstand

## Patentansprüche

1. Bleifreie Lötfolie (1) mit einer Dicke von 50 µm bis 600 µm, um metallische Bauteile und/oder metallisierte/metallbeschichtete Bauteile, d.h. metallische Oberflächenschichten benachbarter Bauteile, miteinander zu verbinden, wobei die Lötfolie (1) so aufgebaut ist, dass in einer Weichlotmatrix (2) zwei oder mehr Drähte jeweils einzeln, parallel zueinander und parallel zu den Bandkanten angeordnet sind, **dadurch gekennzeichnet,**
- **dass** diese jeweils einzeln in der Lötfolie (1) angeordneten Drähte als Verbunddrähte (3) ausgebildet sind, die einen Kern (4) aufweisen der aus einem gegenüber der Weichlotmatrix (2) höherschmelzenden und zugleich festeren Metall, oder einer Metalllegierung, wie aus Kupfer oder einer Kupferbasislegierung, Silber oder Silberbasislegierungen, Nickel oder Nickelbasislegierungen, Gold oder Goldbasislegierungen besteht, um den herum ein Mantel (5) aus einem anderen Metall oder einer anderen Metalllegierung, wie aus reinem Zinn oder einer Zinnbasislegierung, oder aus Indium oder einer Indiumbasislegierung angeordnet ist, und
- **dass** der Mantel (5) der Verbunddrähte (3) bezogen auf den Gesamtdurchmessers des Verbunddrahtes (3) eine Schichtdicke von 2 % bis 20 % aufweist, und
- **dass** die Verbunddrähte (3) längs zur Walzrichtung ausgerichtet, zwischen zwei Weichlotfolien oder zwei Weichlotbändern mittels Walzplattieren bei einer "prozentualen Höhenreduktionen der Ausgangsbänder", ermittelt aus der Differenz zwischen der summarischen Ausgangshöhe der Bänder (6) ohne Hinzurechnung der Höhe der Verbunddrähte (3) und der End-Höhe (H) der Verbundfolie (1) mit eingebetteten Verbunddrähten (3) bezogen auf die summarische Ausgangshöhe der Bänder (6), in Prozent, im Bereich von größer 30 % bis maximal 95 % einplattiert und dadurch stoffschlüssig in der Weichlotmatrix angeordnet sind, und
- **dass** nach dem Walzplattiervorgang, über und unter mindestens einem der Kerne (4) der in der Weichlotmatrix (2) einplattierten Verbunddrähte (3), noch eine Schicht aus Weichlotmaterialien angeordnet ist, welche sich aus dem Bereich der Weichlotmatrix (2) und der Schicht aus dem Mantel (5) der Verbunddrähte (3) zusammensetzt, die in Summe dann an der dünnsten Stelle mindestens 5 µm aber maximal 15 µm beträgt.

2. Bleifreie Lötfolie (1) nach Anspruch 1, **dadurch gekennzeichnet,**
- **dass** die Weichlotmatrix (2), entweder aus bleifreien Zinnbasisloten, reinem Zinn, reinem Indium oder aus Legierungen auf Basis von Indium, wie InSn48 besteht.

3. Bleifreie Lötfolie (1) nach Anspruch 1 oder 2, **dadurch gekennzeichnet,**
- **dass** der Mantel (5) der Verbunddrähte (3) galvanisch oder durch tauchen des Kerns (4) in Metallschmelzen erzeugt wird.

4. Bleifreie Lötfolie (1) nach den Ansprüchen 1 bis 3, **dadurch gekennzeichnet,**
- **dass** als Verbunddrähte (3), Verbunddrähte (3) mit rundem oder ovalem Querschnitt eingesetzt werden.

5. Bleifreie Lötfolie (1) nach den Ansprüchen 1 bis 4, **dadurch gekennzeichnet,**
- **dass** die in einer Lotfolie (1) Einsatz findenden Verbunddrähte (3) im Ausgangszustand alle die gleichen Querschnittsabmessungen besitzen.

6. Bleifreie Lötfolie (1) nach den Ansprüchen 1 bis 4, **dadurch gekennzeichnet,**
- **dass** in einer Lotfolie (1) Einsatz findenden Verbunddrähte (3) im Ausgangszustand unterschiedliche Querschnittsabmessungen besitzen.

7. Bleifreie Lötfolie (1) nach den Ansprüchen 1 bis 6, **dadurch gekennzeichnet,**
- **dass** der minimal zulässige Abstand zwischen den Kernen (4) der Verbunddrähten (3) nach dem Walzprozess 500 µm beträgt, und
- **dass** der minimal zulässige Abstand der Kerne (4) der Verbunddrähte (3) zum Außenrand der Lötfolie (1) nach dem Walzprozess 500 µm beträgt.

8. Bleifreie Lötfolie (1) nach den Ansprüchen 1 bis 7, **dadurch gekennzeichnet,**
- **dass** die Kerne (4) aller in einer Lotfolie (1) Einsatz findenden Verbunddrähte (3) aus einem einheitlichen Kernmaterial bestehen und die Mäntel (5) aller in einer Lotfolie (1) Einsatz findenden Verbunddrähte (3) aus einem einheitlichen Mantelmaterial bestehen.

9. Bleifreie Lötfolie (1) nach den Ansprüchen 1 bis 7, **dadurch gekennzeichnet,**
- **dass** die Kerne (4) aller in einer Lotfolie (1) Einsatz findenden Verbunddrähte (3) aus verschiedenen Kernmaterial bestehen und auch die Mäntel (5) aller in einer Lotfolie (1) Einsatz findenden Verbunddrähte (3) aus unterschiedlichen Mantelmaterialen bestehen.

10. Bleifreie Lötfolie (1) nach den Ansprüchen 1 bis 9, **dadurch gekennzeichnet,**
- **dass** die "prozentualen Höhenreduktionen der Ausgangsbänder", im Bereich von 50 % bis 85 % liegt.

## Claims

1. Lead-free solder foil (1) between 50 µm and 600 µm thick, in order to connect metallic structural components and/or metallised/metal-coated structural components, i.e. metallic surface coatings of neighbouring structural components to one another, wherein the solder foil (1) is built up in such a way, that in a soft solder matrix (2) two or more wires are arranged in each case individually, parallel to one another and parallel to the strip edges, **characterised in,**
- **that** these wires in each case arranged individually in the solder foil (1) are formed as connecting wires (3), which display a core (4) that is comprised of a higher melting point and at the same time more rigid metal, or metal alloy, compared to the soft solder matrix (2), such as copper or a copper-based alloy, silver or silver-based alloys, nickel or nickel-based alloys, gold or gold-based alloys, around which a jacket (5) is arranged, made of a different metal or a different metal alloy, such as of pure tin or a tin-based alloy, or of indium or an indium-based alloy, and
- **that** the jacket (5) of the connecting wires (3), with reference to the overall diameter of the connecting wire (3) has a sheath thickness of between 2 % and 20 %, and
- **that** the connecting wires (3) are arranged longitudinally in the direction of rolling, between two soft solder foils or two soft solder strips using roller cladding or by a "percentage height reduction of the starting strips", determined from the difference between the summary starting height of the strips (6) without adding on the height of the connecting wires (3) and the final height (H) of the connecting foil (1) with embedded connecting wires (3), with reference to the summary starting height of strips (6), are roller clad in percentage terms in the region of from more than 30 % to a maximum of 95 % and in this way are arranged firmly bonded in the soft solder matrix, and
- **that** following the roller cladding process, above and below at least one of the cores (4) of the connecting wires (3) roller clad into the soft solder matrix (2), another sheath of soft solder materials is arranged, which is comprised of the region with the soft solder matrix (2) and the sheath from jacket (5) of connecting wires (3), which then in total amounts to at least 5 µm at the thinnest point, however to a maximum of 15 µm.

2. Lead-free solder foil (1) according to Claim 1, **characterised in,**
- **that** the soft solder matrix (2), is comprised of either lead-free tin-based solder, pure tin, pure indium or out of indium-based alloys, such as InSn48.

3. Lead-free solder foil (1) according to Claim 1 or Claim 2, **characterised in,**
- **that** the jacket (5) of the connecting wires (3) was produced galvanically or by submerging the core (4) in molten metals.

4. Lead-free solder foil (1) according to Claim 1 to Claim 3, **characterised in,**
- **that** connecting wires (3) with a round or an oval cross-section are used as connecting wires (3).

5. Lead-free solder foil (1) according to Claim 1 to Claim 4, **characterised in,**
- **that** the connecting wires (3) used in a solder foil (1) all have the same cross-sectional dimensions in their starting condition.

6. Lead-free solder foil (1) according to Claim 1 to Claim 4, **characterised in,**
- **that** the connecting wires (3) used in a solder foil (1) have different cross-sectional dimensions in their starting condition.

7. Lead-free solder foil (1) according to Claim 1 to Claim 6, **characterised in,**
- **that** the smallest permitted separation between the cores (4) of the connecting wires (3) following the roller cladding process is 500 µm, and
- **that** the smallest permitted separation between cores (4) of the connecting wires (3) to the outer edge of the solder foils (1) following the rolling process is 500 µm.

8. Lead-free solder foil (1) according to Claim 1 to Claim 7, **characterised in,**
- **that** the cores (4) of all the connecting wires (3) used in a solder foil (1) are comprised of a uniform core material and the jacket (5) of all the connecting wires (3) used in a solder foil (1) are comprised of a uniform jacket material.

9. Lead-free solder foil (1) according to Claim 1 to Claim 7, **characterised in,**
- **that** the cores (4) of all the connecting wires (3) used in a solder foil (1) are comprised of different core materials and the jacket (5) of all the connecting wires (3) used in a solder foil (1) are also comprised of different jacket materials.

10. Lead-free solder foil (1) according to Claim 1 to Claim 9, **characterised in,**
- **that** the "percentage height reductions of the starting strips", is in the region of from 50 % to 85 %.

## Revendications

1. Feuille de soudure (1) sans plomb d'une épaisseur de 50 µm à 600 µm destinée à relier ensemble des éléments de construction métalliques et/ou des éléments de construction métallisés/à revêtement métallique, c'est-à-dire des couches superficielles métalliques d'éléments de construction voisins, la feuille de soudure (1) étant conçue de telle sorte que, dans une matrice de brasage tendre (2), deux fils ou davantage sont individuellement orientés parallèlement entre eux et parallèlement aux arêtes de bande, **caractérisée par le fait**
- **que** ces fils disposés individuellement dans la feuille de soudure (1) sont conçus comme fils composites (3) présentant un noyau (4), lequel se compose, relativement à la matrice de brasage tendre (2), d'un métal à point de fusion plus élevé et en même temps plus dur, ou bien d'un alliage métallique, comme le cuivre ou un alliage à base de cuivre, l'argent ou des alliages à base d'argent, le nickel ou des alliages à base de nickel, l'or ou des alliages à base d'or, autour duquel est disposée une enveloppe (5) composée d'un autre métal ou d'un autre alliage métallique, comme l'étain pur ou un alliage à base d'étain ou l'indium ou un alliage à base d'indium, et
- **que** l'enveloppe (5) des fils composites (3), rapportée au diamètre total du fil composite (3), présente une épaisseur de couche allant de 2 % a 20 %, et
- **que** les fils composites (3) sont orientés parallèlement au sens de laminage, disposés entre deux feuilles de brasage tendre ou deux bandes de brasage tendre par placage-laminage pour une "réduction de hauteur des bandes de sortie exprimée en pourcentage", déterminée au moyen de la différence entre la hauteur de sortie sommaire des bandes (6) sans ajout de la hauteur des fils composites (3) et la hauteur (H) finale de la feuille composite (1) avec fils composites (3) intégrés, rapportée à la hauteur de sortie sommaire des bandes (6), en pourcentage, plaqués dans une plage allant de supérieur à 30 % jusqu'à un maximum de 95 %, et ainsi reliés par continuité de matière dans la matrice de brasage tendre, et
- **que**, après le processus de placage-laminage, au-dessus et en-dessous d'au moins l'un des noyaux (4) des fils composites (3) plaqués dans la matrice de brasage tendre (2), est disposée une autre couche supplémentaire de matériaux de brasage tendre, laquelle se compose de la zone de matrice de brasage tendre (2) et de la couche provenant de l'enveloppe (5) des fils composites (3), laquelle représente dans son ensemble à l'endroit le plus fin au moins 5 µm, mais pas plus de 15 µm.

2. Feuille de soudure (1) sans plomb selon l'exigence 1 **caractérisée par le fait,**
- **que** la matrice de brasage tendre (2) se compose soit de brasages à base d'étain sans plomb, d'étain pur, d'indium pur, ou d'alliages à base d'indium, comme InSn48.

3. Feuille de soudure (1) sans plomb selon l'exigence 1 ou 2, **caractérisée par le fait,**
- **que** l'enveloppe (5) des fils composites(3) est produite de manière galvanique ou par immersion du noyau (4) dans du métal fondu.

4. Feuille de soudure (1) sans plomb selon les exigences 1 à 3, **caractérisée par le fait,**
- **que**, comme fils composites (3), des fils composites (3) de section ronde ou ovale sont utilisés.

5. Feuille de soudure (1) sans plomb selon les exigences 1 à 4, **caractérisée par le fait,**
- **que** les fils composites (3) mis en oeuvre dans une feuille de soudure (1) ont tous les mêmes dimensions de section à l'état initial.

6. Feuille de soudure (1) sans plomb selon les exigences 1 à 4, **caractérisée par le fait,**
- **que** les fils composites (3) mis en oeuvre dans une feuille de soudure (1) ont tous des dimensions de section à l'état initial différentes.

7. Feuille de soudure (1) sans plomb selon les exigences 1 à 6, **caractérisée par le fait,**
- **que** la distance minimale admissible entre les noyaux (4) des fils composites (3) est de 500 µm après le processus de placage, et
- **que** la distance minimale admissible des noyaux (4) des fils composites (3) vers le bord extérieur de la feuille de soudure (1) est de 500 µm après le processus de placage.

8. Feuille de soudure (1) sans plomb selon les exigences 1 à 7, **caractérisée par le fait,**
- **que** les noyaux (4) de tous les fils composites (3) mis en oeuvre dans une feuille de soudure (1) se composent d'un matériau de noyau unique et que les enveloppes (5) de tous les fils composites (3) mis en oeuvre dans une feuille de soudure (1) se composent d'un matériau d'enveloppe unique.

9. Feuille de soudure (1) sans plomb selon les exigences 1 à 7, **caractérisée par le fait,**
- **que** les noyaux (4) de tous les fils composites (3) mis en oeuvre dans une feuille de soudure (1) se composent de différents matériaux de noyau et également que les enveloppes (5) de tous les fils composites (3) mis en oeuvre dans une feuille de soudure (1) se composent de différents matériaux d'enveloppe.

10. Feuille de soudure (1) sans plomb selon les exigences 1 à 9, **caractérisée par le fait,**
- **que** la "réduction de hauteur des bandes de sortie exprimée en pourcentage" se situe dans une plage allant de 50 % à 85 %.
